(19) Europäisches Patentamt / European Patent Office / Office européen des brevets

(11) **EP 4 204 360 B1**

(12) **EUROPÄISCHE PATENTSCHRIFT**

(45) Veröffentlichungstag und Bekanntmachung des Hinweises auf die Patenterteilung:
**31.12.2025 Patentblatt 2026/01**

(21) Anmeldenummer: **20820064.2**

(22) Anmeldetag: **30.11.2020**

(51) Internationale Patentklassifikation (IPC):
*C01B 33/021* (2006.01)   *C23C 16/24* (2006.01)
*H01M 4/134* (2010.01)   *C23C 16/04* (2006.01)
*C23C 16/44* (2006.01)   *H01M 4/131* (2010.01)
*H01M 4/1395* (2010.01)   *H01M 4/36* (2006.01)
*H01M 4/38* (2006.01)   *H01M 4/48* (2010.01)
*H01M 4/587* (2010.01)   *H01M 4/62* (2006.01)
*H01M 10/0525* (2010.01)   *H01M 4/1391* (2010.01)

(52) Gemeinsame Patentklassifikation (CPC):
C01B 33/021; C23C 16/045; C23C 16/24;
C23C 16/4417; H01M 4/131; H01M 4/134;
H01M 4/1391; H01M 4/1395; H01M 4/364;
H01M 4/386; H01M 4/483; H01M 4/587;
H01M 4/624; H01M 10/0525; Y02E 60/10

(86) Internationale Anmeldenummer:
**PCT/EP2020/083890**

(87) Internationale Veröffentlichungsnummer:
**WO 2022/111828 (02.06.2022 Gazette 2022/22)**

(54) **SILICIUM ENTHALTENDE MATERIALIEN**

SILICON-CONTAINING MATERIALS

MATÉRIAUX CONTENANT DU SILICIUM

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**05.07.2023 Patentblatt 2023/27**

(73) Patentinhaber: **Wacker Chemie AG**
**81671 München (DE)**

(72) Erfinder:
• **DRÄGER, Christoph**
**81369 München (DE)**

• **HANELT, Eckhard**
**82269 Geltendorf (DE)**
• **KALYAKINA, Alena**
**81379 München (DE)**
• **KLEINLEIN, Claudia**
**84489 Burghausen (DE)**

(74) Vertreter: **Belz, Ferdinand et al**
**Wacker Chemie AG**
**Gisela-Stein-Straße 1**
**81671 München (DE)**

(56) Entgegenhaltungen:
**WO-A1-2017/040299     WO-A1-2018/145765**
**WO-A1-2020/128523**

## Beschreibung

Die vorliegende Erfindung betrifft Silicium enthaltende Materialien basierend auf porösen Partikeln und Silicium, Verfahren zur Herstellung der Silicium enthaltenden Materialien sowie deren Verwendung als Aktivmaterialien in Anoden für Lithium-Ionen-Batterien.

Als Speichermedien für elektrischen Strom sind Lithium-Ionen-Batterien gegenwärtig die praxistauglichen elektrochemischen Energiespeicher mit den höchsten Energiedichten. Lithium-Ionen-Batterien werden vor allem im Bereich der tragbaren Elektronik, für Werkzeuge und auch für elektrisch angetriebene Transportmittel, wie Fahrräder, Roller oder Automobile, genutzt. Als Aktivmaterial für die negative Elektrode ("Anode") entsprechender Batterien ist gegenwärtig graphitischer Kohlenstoff weit verbreitet. Nachteilig ist jedoch die relativ niedrige elektrochemische Kapazität von derartigen graphitischen Kohlenstoffen, die theoretisch höchstens 372 mAh pro Gramm Graphit beträgt und somit nur etwa einem Zehntel der mit Lithiummetall theoretisch erreichbaren elektrochemischen Kapazität entspricht. Alternative Aktivmaterialien für die Anode verwenden einen Zusatz von Silicium, wie beispielsweise in der EP 1730800 B1, der US 10,559,812 B2, der US 10,819,400 B2, oder der EP 3335262 B1 beschrieben. Silicium bildet mit Lithium binäre elektrochemisch aktive Legierungen, die sehr hohe elektrochemisch erreichbare Lithiumgehalte von bis zu 3579 mAh pro Gramm Silicium ermöglichen [M. Obrovac, V.L. Chevrier Chem. Rev. 2014, 114, 11444].

Die Ein- und Auslagerung von Lithiumionen in Silicium ist mit dem Nachteil verbunden, dass dabei eine sehr starke Volumenänderung eintritt, die bei vollständiger Einlagerung bis zu 300% erreichen kann. Derartige Volumenänderungen setzen das Silicium-haltige Aktivmaterial einer starken mechanischen Belastung aus, aufgrund derer das Aktivmaterial schließlich auseinanderbrechen kann. Dieser auch als elektrochemische Mahlung bezeichnete Prozess führt im Aktivmaterial und in der Elektrodenstruktur zu einem Verlust der elektrischen Kontaktierung und damit zum nachhaltigen, irreversiblen Verlust der Kapazität der Elektrode.

Weiterhin reagiert die Oberfläche des Silicium enthaltenden Aktivmaterials mit Bestandteilen des Elektrolyten unter kontinuierlicher Bildung passivierender Schutzschichten (Solid Electrolyte Interphase; SEI). Die gebildeten Komponenten sind nicht mehr elektrochemisch aktiv. Das darin gebundene Lithium steht dem System nicht mehr zur Verfügung, was zu einem ausgeprägten kontinuierlichen Kapazitätsverlust der Batterie führt. Aufgrund der extremen Volumenänderung des Siliciums während des Lade- bzw. Entladevorgangs der Batterie bricht die SEI regelmäßig auf, wodurch weitere, noch nicht belegte Oberflächen des Silicium enthaltenden Aktivmaterials freigelegt werden, die dann einer weiteren SEI-Bildung ausgesetzt sind. Da in der Vollzelle die Menge an mobilem Lithium, welches der nutzbaren Kapazität entspricht, durch das Kathodenmaterial begrenzt ist, wird dieses zunehmend verbraucht und die Kapazität der Zelle sinkt bereits nach wenigen Zyklen in anwendungstechnisch inakzeptablem Ausmaß.

Die Abnahme der Kapazität im Laufe mehrerer Lade- und Entladezyklen wird auch als Fading oder kontinuierlicher Kapazitätsverlust bezeichnet und ist in der Regel irreversibel.

Als Aktivmaterialien für Anoden von Lithium-Ionen-Batterien sind eine Reihe von Silicium-Kohlenstoff-Kompositpartikeln beschrieben worden, in denen das Silicium ausgehend von gasförmigen oder flüssigen Präkursoren in poröse Kohlenstoffpartikel, eingelagert wird. Beispielsweise beschreibt die US 10,147,950 B2 die Abscheidung von Silicium aus Monosilan $SiH_4$ in einem porösen Kohlenstoff in einem Rohrofen oder vergleichbaren Ofentypen bei erhöhten Temperaturen von 300 bis 900°C, bevorzugt unter Bewegung der Partikel durch einen CVD- ("chemical vapor deposition") oder PE-CVD-Prozess ("plasma-enhanced chemical vapor deposition"). Eine analoge Vorgehensweise ist in US 10,424,786 B1 beschrieben, in der die Silicium-Präkursoren als Mischung mit Inertgas bei einem Gesamtdruck von 1,013 bar eingebracht werden. Die WO2012/097969 A1 beschreibt die Abscheidung von feinsten Siliciumpartikeln im Bereich von 1 bis 20 nm durch Erwärmung von Silanen als Silicium-Präkursor auf porösen Kohlenstoffträgern bei 200 bis 950°C, wobei das Silan mit einem Inertgas verdünnt wird, um Agglomeration der abgeschiedenen Silicium-Partikel bzw. die Bildung dicker Schichten zu vermeiden, wobei die Abscheidung in einem Druckbereich von 0,1 bis 5 bar erfolgt.

Den aus den beschriebenen Verfahren zugänglichen Silicium enthaltenden Materialien ist gemein, dass bei der Verwendung des Silicium enthaltenden Materials als Aktivmaterial in Anoden für Lithium-Ionen-Batterien neben dem Silicium auch der Kohlenstoff in gewissem Maß zur elektrochemischen Kapazität der Silicium enthaltenden Materialien beiträgt. Aufgrund der in den meisten Fällen amorphen Struktur der verwendeten Kohlenstoffe verbleibt bei elektrochemischer Zyklisierung in einem eingeschränkten Potentialfenster, welches insbesondere im Fall der Anwendung in Mobiltelefonen nicht den komplett theoretisch möglichen Bereich umfasst, ein überproportional großer Anteil an Lithium im Silicium enthaltenden Material und steht nicht für die weitere Zyklisierung zur Verfügung ("Trapping"). Somit kann nicht die gesamte Kapazität genutzt werden, was für die Nutzung der bekannten Silicium enthaltenden Materialien in derartigen Anwendungen nachteilig ist.

Zudem ist nachteilig, dass die Abscheidung des Siliciums bei Temperaturen oberhalb circa 800°C nurmehr bedingt möglich ist, da aufgrund der hohen Reaktivität des amorphen Kohlenstoffs gegenüber gasförmigen Silicium-Präkursoren die Bildung von Siliciumcarbid erfolgen kann, was die Kapazität der Silicium enthaltenden Materialien zur Speicherung von Lithium-Ionen stark senken kann, da Siliciumcarbid im Gegensatz zum Silicium nicht zur elektrochemischen Speicherung von Lithium-Ionen genutzt werden kann. Weiterhin besteht bei diesen hohen Temperaturen die Gefahr, dass zumindest ein Teil der Porosität der porösen Partikel durch Sinterprozesse verloren geht.

Die US 9,005,818 B2 beschreibt Silicium enthaltende Anodenaktivmaterialien für Lithium-Ionen-Batterien, die durch Abscheidung von Silicium aus gasförmigen Silicium-Präkursoren in eine mesoporöse Siliciumdioxid-Matrix erhalten werden. Das so erhaltene Produkt enthält Silicium in einer Menge von 0,05 bis 100%, bezogen auf das Gewicht der mesoporösen Siliciumdioxid-Matrix, und weist ein durch Stickstoff-Sorption bestimmtes Porenvolumen von 0,2 bis 0,5 ml/g sowie BET-Oberflächen von 150 bis 1000 m$^2$/g auf. Die initiale Coulomb-Effizienz wie auch die Zyklisierungsstabilität entsprechender Lithium-Ionen-Batterien können noch nicht befriedigen.

WO 2020/128523 A1, WO 2017/040299 A1 und WO 2018/145765 A1 offenbaren jeweils ein Silicium enthaltendes Material basierend auf einem oder mehreren porösen Partikeln und Silicium, wobei sich das Silicium in Poren und auf der Oberfläche der porösen Partikel befindet und das Silicium enthaltende Material eine spezifische Oberfläche von höchstens 50 m$^2$/g, bestimmt durch Stickstoff-Sorption und BET-Auswertung, aufweist.

Vor diesem Hintergrund bestand die Aufgabe, Silicium enthaltende Materialien bereitzustellen, die bei Einsatz als Aktivmaterial in Anoden von Lithium-Ionen-Batterien einen geringen initialen und kontinuierlichen Verlust an in der Zelle verfügbarem Lithium aufweisen und somit hohe Coulomb-Effizienzen und zudem in den Folgezyklen ein stabiles elektrochemisches Verhalten ermöglichen. Vorzugsweise sollte das Fading oder Trapping möglichst gering sein.

Diese Aufgabe konnte überraschend mit Silicium enthaltenden Materialien gelöst werden basierend auf einem oder mehreren porösen Partikeln und Silicium, wobei sich das Silicium in Poren und auf der Oberfläche der porösen Partikel befindet und die Silicium enthaltenden Materialien eine spezifische Oberfläche von höchstens 50 m$^2$/g, bestimmt durch Stickstoff-Sorption und BET-Auswertung, aufweisen, dadurch gekennzeichnet, dass die porösen Partikel einen mittleren elektrischen Partikelwiderstand von zumindest 2 kOhm und eine reversible Delithiierungs-Kapazität $\beta$ von höchstens 100 mAh/g aufweisen. Dies ist insbesondere überraschend, als dass üblicherweise bei Aktivmaterialien für Lithium-Ionen-Batterien, welche eine geringe elektronische Leitfähigkeit und damit einen hohen elektrischen Partikelwiderstand aufweisen, mit einer elektronisch leitfähigen Schicht beispielsweise aus Kohlenstoff versehen werden, welche einen sehr geringen elektronischen Widerstand aufweist. Dies ist beispielsweise für das als Kathodenaktivmaterial verwendete Lithiumeisenphosphat wie beispielsweise in der EP 3 678 990 A1 oder auch für das als Anodenaktivmaterial eingesetzte Siliciumsuboxid SiOx beispielsweise aus der EP 1 323 783 B1 bekannt. Insofern wird im Allgemeinen davon ausgegangen, dass der mittlere Partikelwiderstand poröser Partikel als Ausgangsmaterial für Silicium enthaltende Materialien für den Einsatz als Aktivmaterial in Anoden von Lithium-Ionen-Batterien weniger als 2 kOhm betragen sollte, um eine vollständige Nutzung der Kapazität solcher Silicium enthaltender Materialien und die nötige Leitfähigkeit innerhalb der Elektrode zu ermöglichen. Typischerweise weisen poröse Kohlenstoffe derart niedrige Partikelwiderstände auf. Im Gegensatz hierzu wurde nun überraschend gefunden, dass auch mit einem mittleren elektrischen Partikelwiderstand der porösen Partikel von mehr als 2 kOhm die elektrische Leitfähigkeit des resultierenden Silicium enthaltenden Materials ausreichend ist, um die vollständige Kapazität in der Anwendung als Aktivmaterial in Anoden von Lithium-Ionen-Batterien nutzbar zu machen.

Gegenstand der Erfindung ist ein Silicium enthaltendes Material basierend auf einem oder mehreren porösen Partikeln und Silicium, wobei sich das Silicium in Poren und auf der Oberfläche der porösen Partikel befindet und das Silicium enthaltende Material eine spezifische Oberfläche von höchstens 50 m$^2$/g, bestimmt durch Stickstoff-Sorption und BET-Auswertung, aufweist, dadurch gekennzeichnet, dass die porösen Partikel

a) einen mittleren elektrischen Partikelwiderstand von zumindest 2 kOhm und
b) eine reversible Delithiierungs-Kapazität $\beta$ von höchstens 100 mAh/g aufweisen.

Als poröse Partikel für die Silicium enthaltenden Materialien können Materialien, deren Partikel einen mittleren elektrischen Partikelwiderstand von zumindest 2 kOhm aufweisen und die eine reversible Delithiierungs-Kapazität $\beta$ von höchstens 100 mAh/g, vorzugsweise 0 bis 100 mAh/g, besonders bevorzugt 2 bis 80 mAh/g aufweisen, zum Einsatz kommen.

Die porösen Partikel basieren dabei auf einem oder mehreren Materialien, ausgewählt aus der Gruppe enthaltend Oxide, wie Siliciumdioxid, Aluminiumoxid, Silicium-Aluminium-Mischoxide, Magnesiumoxid, Bleioxide und Zirkoniumoxid; Carbide, wie Siliciumcarbide und Borcarbide; Nitride, wie Siliciumnitride und Bornitride; sowie keramische Werkstoffe, wie sie sich vorzugsweise durch folgende Komponentenformel beschreiben lassen: $Al_aB_bC_cMg_dN_eO_fSi_g$ mit $0 \leq a, b, c, d, e, f, g \leq 1$; mit mindestens zwei Koeffizienten a bis g > 0 und $a*3 + b*3 + c*4 + d*2 + g*4 \geq e*3 + f*2$.

Die keramischen Werkstoffe können beispielsweise binäre, ternäre, quaternäre, quinäre, senäre oder septernäre Verbindungen sein. Bevorzugt sind keramische Werkstoffe mit folgenden Komponentenformeln:

Nichtstöchiometrische Bornitride $BN_z$ mit z = 0,2 bis 1,
Nichtstöchiometrische Kohlenstoffnitride $CN_z$ mit z = 0,1 bis 4/3,
Borcarbonitride $B_xCN_z$ mit x = 0,1 bis 20 und z = 0,1 bis 20, wobei gilt $x*3 + 4 \geq z*3$,
Bornitridooxide $BN_zO_r$ mit z = 0,1 bis 1 und r = 0,1 bis 1, wobei gilt $3 \geq r*2 + z*3$,

Borcarbonitridooxide $B_xCN_zO_r$ mit x = 0,1 bis 2, z = 0,1 bis 1 und r = 0,1 bis 1, wobei gilt x*3 + 4 ≥ r*2 + z*3,

Siliciumcarbooxide $Si_xCO_z$ mit x = 0,1 bis 2 und z = 0,1 bis 2, wobei gilt x*4 + 4 ≥ z*2,

Siliciumcarbonitride $Si_xCN_z$ mit x = 0,1 bis 3 und z = 0,1 bis 4, wobei gilt x*4 + 4 ≥ z*3,

Siliciumborocarbonitride $Si_wB_xCN_z$ mit w = 0,1 bis 3, x = 0,1 bis 2 und z= 0,1 bis 4, wobei gilt w*4 + x*3 + 4 ≥ z*3,

Siliciumborocarbooxide $Si_wB_xCO_z$ mit w = 0,10 bis 3, x = 0,1 bis 2 und z = 0,1 bis 4, wobei gilt w*4 + x*3 + 4 ≥ z*2,

Siliciumborocarbonitridooxide $Si_vB_wCN_xO_z$ mit v = 0,1 bis 3, w = 0,1 bis 2, x = 0,1 bis 4 und z = 0,1 bis 3, wobei gilt v*4 + w*3 + 4 ≥ x*3 + z*2 und

Aluminiumborosilicocarbonitridooxide $Al_uB_vSi_xCN_wO_z$ mit u = 0,1 bis 2, v = 0,1 bis 2, w = 0,1 bis 4, x = 0,1 bis 2 und z = 0,1 bis 3, wobei gilt u*3 + v*3 + x*4 + 4 ≥ w*3 + z*2.

Bevorzugte poröse Partikel basieren auf Siliciumdioxid, Bornitrid, Siliciumcarbid, Siliciumnitrid oder auf Mischwerkstoffen auf Basis dieser Verbindungen, insbesondere auf Siliciumdioxid oder Bornitrid.

Besonders bevorzugte poröse Partikel sind poröse Bornitrid-Partikel, insbesondere poröse Siliciumoxid-Partikel, besonders bevorzugt sind nanoporöse Siliciumoxid-Partikel.

Die Synthese der porösen Partikel kann allgemein über Sol-Gel basierte Synthesen erfolgen, wie beispielsweise für Silicagele, Aerogele oder Xerogele durch M. Kato, K. Sakai-Kato, T Toyo'oka, J. Sep. Science, 2005, 28, 1893-1908 beschrieben. $SiO_2$-Materialien mit Porenstrukturen im Größenbereich kleiner 10 nm bei gleichzeitig hohem Porenvolumen werden vorzugsweise nach Sol-Gel-Verfahren über sehr kleine Basis-Einheiten ($SiO_2$-Partikel, Polyhedral Oligomeric Silsesquioxane (POSS)-Einheiten) hergestellt. Die Porencharakteristik kann beispielsweise über die Reaktionsbedingungen, wie Temperatur, Katalysatortyp und Konzentration, oder auch die Silanfunktionalisierung eingestellt werden. Weitere Einflussfaktoren sind beispielsweise die Trocknungsbedingungen des Gels oder dessen Nachbehandlung, wie Tempern. Porositäten oberhalb von 90 % bei Porengrößen kleiner als 100 nm sind beispielsweise durch überkritische Trocknung des Gels zugänglich. Xerogele mit Porengrößen unterhalb von 10 nm sind auch durch konvektive Trocknung erhältlich.

Bevorzugt besitzen die porösen Partikel eine durch Heliumpyknometrie bestimmte Dichte von 0,1 bis 7 g/cm$^3$ und besonders bevorzugt von 0,3 bis 3 g/cm$^3$. Dies ist vorteilhaft zur Steigerung der gravimetrischen Kapazität (mAh/cm$^3$) von Lithium-Ionen-Batterien.

Die porösen Partikel weisen eine volumengewichtete Partikelgrößenverteilung mit Durchmesser-Perzentilen $d_{50}$ auf von vorzugsweise ≥ 0,5 μm, besonders bevorzugt ≥ 1,5 μm und am meisten bevorzugt ≥ 2 μm. Die Durchmesser-Perzentile $d_{50}$ sind vorzugsweise ≤ 20 μm, besonders bevorzugt ≤ 12 μm und am meisten bevorzugt ≤ 8 μm.

Die volumengewichtete Partikelgrößenverteilung der porösen Partikel liegt vorzugsweise zwischen den Durchmesser-Perzentilen $d_{10}$ ≥ 0,2 μm und $d_{90}$ ≤ 20,0 μm, besonders bevorzugt zwischen $d_{10}$ ≥ 0,4 μm und $d_{90}$ ≤ 15,0 μm und am meisten bevorzugt zwischen $d_{10}$ ≥ 0,6 μm bis $d_{90}$ ≤ 12,0 μm.

Die porösen Partikel haben eine volumengewichtete Partikelgrößenverteilung mit Durchmesser-Perzentilen $d_{10}$ von vorzugsweise ≤ 10 μm, besonders bevorzugt ≤ 5 μm, insbesondere bevorzugt ≤ 3 μm und am meisten bevorzugt ≤ 2 μm. Die Durchmesser-Perzentile $d_{10}$ sind vorzugsweise ≥ 0,2 μm, besonders bevorzugt ≥ 0,5 und am meisten bevorzugt ≥ 1 μm.

Die porösen Partikel haben eine volumengewichtete Partikelgrößenverteilung mit Durchmesser-Perzentilen $d_{90}$ von vorzugsweise ≥ 4 μm und besonders bevorzugt ≥ 8 μm. Die Durchmesser-Perzentile $d_{90}$ sind vorzugsweise ≤ 18 μm, besonders bevorzugt ≤ 15 und am meisten bevorzugt ≤ 13 μm.

Die volumengewichtete Partikelgrößenverteilung der porösen Partikel hat eine Breite $d_{90}$-$d_{10}$ von vorzugsweise ≤ 15,0 μm, mehr bevorzugt ≤ 12,0 μm, besonders bevorzugt ≤ 10,0 μm, insbesondere bevorzugt ≤ 8,0 μm und am meisten bevorzugt ≤ 4,0 μm. Die volumengewichtete Partikelgrößenverteilung der porösen Partikel hat eine Breite $d_{90}$-$d_{10}$ von vorzugsweise ≥ 0,6 μm, besonders bevorzugt ≥ 0,7 μm und am meisten bevorzugt ≥ 1,0 μm.

Die volumengewichtete Partikelgrößenverteilung ist bestimmbar nach ISO 13320 mittels statischer Laserstreuung unter Anwendung des Mie-Modells mit dem Messgerät Horiba LA 950 mit Ethanol als Dispergiermedium für die porösen Partikel.

Die porösen Partikel können beispielsweise isoliert oder agglomeriert vorliegen. Die porösen Partikel sind vorzugsweise nicht aggregiert und vorzugsweise nicht agglomeriert. Aggregiert bedeutet allgemein, dass im Zuge der Herstellung der porösen Partikel zunächst Primärpartikel gebildet werden und zusammenwachsen und/oder Primärpartikel beispielsweise über kovalente Bindungen miteinander verknüpft sind und auf diese Weise Aggregate bilden. Primärpartikel sind allgemein isolierte Partikel. Aggregate oder isolierte Partikel können Agglomerate bilden. Agglomerate sind eine lose Zusammenballung von Aggregaten oder Primärpartikeln, die beispielsweise über Van-der-Waals-Wechselwirkungen oder Wasserstoffbrückenbindungen miteinander verknüpft sind. Agglomerierte Aggregate können nach gängigen Knet- und Dispergierverfahren leicht wieder in Aggregate aufgespalten werden. Aggregate lassen sich mit diesen Verfahren nicht oder nur teilweise in die Primärpartikel zerlegen. Das Vorliegen der porösen Partikel in Form von Aggregaten, Agglomeraten oder isolierten Partikeln kann beispielsweise mittels herkömmlicher Raster-Elektronen-Mikroskopie (REM) sichtbar gemacht werden. Statische Lichtstreuungsmethoden zur Bestimmung der Teilchengrößenverteilungen oder Partikeldurchmessern von Matrixpartikeln können dagegen nicht zwischen Aggregaten oder Agglomeraten unterscheiden.

Die porösen Partikel können eine beliebige Morphologie aufweisen, also beispielsweise splittrig, plattig, sphärisch oder auch nadelförmig sein, wobei splittrige oder sphärische Partikel bevorzugt sind.

Die Morphologie kann beispielsweise durch die Sphärizität $\psi$ oder die Sphärizität S charakterisiert werden. Gemäß der Definition von Wadell ist die Sphärizität $\psi$ das Verhältnis aus der Oberfläche einer Kugel gleichen Volumens zur tatsächlichen Oberfläche eines Körpers. Im Falle einer Kugel hat $\psi$ den Wert 1. Nach dieser Definition haben die porösen Partikel eine Sphärizität $\psi$ von vorzugsweise 0,3 bis 1,0 besonders bevorzugt von 0,5 bis 1,0 und am meisten bevorzugt von 0,65 bis 1,0.

Die Sphärizität $S$ ist das Verhältnis aus dem Umfang eines äquivalenten Kreises mit gleicher Fläche A wie die Projektion des auf eine Fläche projizierten Partikels und dem gemessenen Umfang U dieser Projektion: $S = 2\sqrt{\pi A}/U$ . Im Falle eines ideal kreisförmigen Partikels hätte $S$ den Wert 1. Für die porösen Partikel liegt die Sphärizität $S$ im Bereich von vorzugsweise 0,5 bis 1,0 und besonders bevorzugt von 0,65 bis 1,0, bezogen auf die Perzentile $S_{10}$ bis $S_{90}$ der Sphärizitäts-Anzahlverteilung. Die Messung der Sphärizität $S$ erfolgt beispielsweise anhand von Aufnahmen einzelner Partikel mit einem optischen Mikroskop oder bei Partikeln < 10 $\mu$m bevorzugt mit einem Rasterelektronenmikroskop durch grafische Auswertung mittels einer Bildanalysesoftware, wie beispielsweise ImageJ.

Die porösen Partikel weisen bevorzugt ein gaszugängliches Porenvolumen von $\geq$ 0,2 cm$^3$/g, besonders bevorzugt $\geq$ 0,6 cm$^3$/g und am meisten bevorzugt $\geq$ 1,0 cm$^3$/g auf. Dies ist förderlich, um Lithium-Ionen-Batterien mit hoher Kapazität zu erhalten. Das gaszugängliche Porenvolumen wird durch Gassorptionmessungen mit Stickstoff gemäß DIN 66134 bestimmt.

Die porösen Partikel sind vorzugsweise offenporig. Offenporig bedeutet allgemein, dass Poren mit der Oberfläche von Partikeln verbunden sind, beispielsweise über Kanäle, und vorzugsweise mit der Umgebung in stofflichem Austausch, insbesondere in Austausch von gasförmigen Verbindungen, stehen können. Dies lässt sich anhand von Gassorptionsmessungen (Auswertung nach Brunauer, Emmett und Teller, "BET"), also der spezifischen Oberfläche nachweisen.

Die porösen Partikel weisen spezifische Oberflächen von bevorzugt $\geq$ 50 m$^2$/g, besonders bevorzugt $\geq$ 500 m$^2$/g und am meisten bevorzugt $\geq$ 1000 m$^2$/g auf. Die BET-Oberfläche wird gemäß DIN 66131 (mit Stickstoff) bestimmt.

Die Poren der porösen Partikel können beliebige Durchmesser aufweisen, also allgemein im Bereich von Makroporen (> 50 nm), Mesoporen (2 bis 50 nm) und Mikroporen (< 2 nm) liegen. Die porösen Partikel können in beliebigen Mischungen verschiedener Porentypen eingesetzt werden. Bevorzugt werden poröse Partikel mit höchstens 30 % Makroporen, bezogen auf das Gesamtporenvolumen, besonders bevorzugt poröse Partikel ohne Makroporen und ganz besonders bevorzugt poröse Partikel mit zumindest 50 % Poren mit einem mittleren Porendurchmesser unter 5 nm eingesetzt. Insbesondere bevorzugt weisen die porösen Partikel ausschließlich Poren mit einem Porendurchmesser kleiner 2 nm auf (Bestimmungsmethode: Porengrößenverteilung nach BJH (Gasadsorption) gemäß DIN 66134 im Mesoporenbereich und nach Horvath-Kawazoe (Gasadsorption) gemäß DIN 66135 im Mikroporenbereich; die Bewertung der Porengrößenverteilung im Makroporen-Bereich erfolgt durch Quecksilberporosimetrie nach DIN ISO 15901-1).

Bevorzugt sind poröse Partikel mit gasunzugänglichem Porenvolumen von kleiner 0,3 cm$^3$/g und besonders bevorzugt kleiner 0,15 cm$^3$/g. Auch damit kann die Kapazität der Lithium-Ionen-Batterien gesteigert werden. Das gasunzugängliche Porenvolumen kann mittels der folgenden Formel bestimmt werden:

Gasunzugängliches Porenvolumen = 1/Reinmaterialdichte - 1/Skelettdichte.

Dabei ist die Reinmaterialdichte eine theoretische Dichte des Materials, basierend auf der Phasenzusammensetzung oder der Dichte des Reinstoffes (Dichte des Materials als hätte es keine geschlossene Porosität). Daten zu Reinmaterialdichten lassen sich durch den Fachmann beispielsweise dem Ceramic Data Portal des National Institute of Standards (NIST, https://srdata.nist.gov/CeramicDataPortal/scd) entnehmen. Beispielsweise beträgt die Reinmaterialdichte von Siliciumoxid SiO$_2$ 2,203 g/cm$^3$, von Bornitrid BN 2,25 g cm$^3$, von Siliciumnitrid Si$_3$N$_4$ 3,44 g/cm$^3$ und von Siliciumcarbid SiC 3,21 g/cm$^3$.

Die Skelettdichte ist die tatsächliche, durch Heliumpyknometrie bestimmte Dichte der porösen Partikel (Gaszugänglich).

Klarstellend sei angemerkt, dass die porösen Partikel vom Silicium enthaltenden Material verschieden sind. Die porösen Partikel fungieren als Startmaterial zur Herstellung des Silicium enthaltenden Materials. Vorzugsweise befindet sich in den Poren der porösen Partikel und auf der Oberfläche der porösen Partikel allgemein kein Silicium, insbesondere kein Silicium, das durch Abscheiden von Silicium-Präkursoren erhalten wird.

Das mittels Abscheidung von Silicium in Poren und auf der Oberfläche der porösen Partikel erhältliche Silicium enthaltende Material weist eine volumengewichtete Partikelgrößenverteilung mit Durchmesser-Perzentilen $d_{50}$ vorzugs-

weise in einem Bereich von 0,5 bis 20 $\mu$m auf. Bevorzugt beträgt der $d_{50}$-Wert zumindest 1,5 $\mu$m, und besonders bevorzugt zumindest 2 $\mu$m. Die Durchmesser-Perzentile $d_{50}$ betragen vorzugsweise höchstens 13 $\mu$m und besonders bevorzugt höchstens 8 $\mu$m.

Die volumengewichtete Partikelgrößenverteilung des Silicium enthaltenden Materials liegt vorzugsweise zwischen den Durchmesser-Perzentilen $d_{10} \geq 0,2$ $\mu$m und $d_{90} \leq 20,0$ $\mu$m, besonders bevorzugt zwischen $d_{10} \geq 0,4$ $\mu$m und $d_{90} \leq 15,0$ $\mu$m und am meisten bevorzugt zwischen $d_{10} \geq 0,6$ $\mu$m bis $d_{90} \leq 12,0$ $\mu$m.

Das Silicium enthaltende Material hat eine volumengewichtete Partikelgrößenverteilung mit Durchmesser-Perzentilen $d_{10}$ von vorzugsweise $\leq 10$ $\mu$m, besonders bevorzugt $\leq 5$ $\mu$m, insbesondere bevorzugt $\leq 3$ $\mu$m und am meisten bevorzugt $\leq 1$ $\mu$m. Die Durchmesser-Perzentile $d_{10}$ sind vorzugsweise $\geq 0,2$ $\mu$m, besonders bevorzugt $\geq 0,4$ $\mu$m und am meisten bevorzugt $\geq 0,6$ $\mu$m.

Das Silicium enthaltende Material hat eine volumengewichtete Partikelgrößenverteilung mit Durchmesser-Perzentilen $d_{90}$ von vorzugsweise $\geq 5$ $\mu$m und besonders bevorzugt $\geq 10$ $\mu$m. Die Durchmesser-Perzentile $d_{90}$ sind vorzugsweise $\leq 20,0$ $\mu$m, besonders bevorzugt $\leq 15,0$ $\mu$m und am meisten bevorzugt $\leq 12,0$ $\mu$m.

Die volumengewichtete Partikelgrößenverteilung des Silicium enthaltenden Materials hat eine Breite $d_{90}$-$d_{10}$ von vorzugsweise $\leq 15,0$ $\mu$m, besonders bevorzugt $\leq 12,0$ $\mu$m, mehr bevorzugt $\leq 10,0$ $\mu$m, insbesondere bevorzugt $\leq 8,0$ $\mu$m und am meisten bevorzugt $\leq 4,0$ $\mu$m. Die volumengewichtete Partikelgrößenverteilung des Silicium enthaltenden Materials hat eine Breite $d_{90}$-$d_{10}$ von vorzugsweise $\geq 0,6$ $\mu$m, besonders bevorzugt $\geq 0,7$ $\mu$m und am meisten bevorzugt $\geq 1,0$ $\mu$m.

Das Silicium enthaltende Material liegt vorzugsweise in Form von Partikeln vor. Die Partikel können isoliert oder agglomeriert vorliegen. Das Silicium enthaltende Aktivmaterial ist vorzugsweise nicht aggregiert und vorzugsweise nicht agglomeriert. Die Begriffe isoliert, agglomeriert und nicht aggregiert sind weiter oben in Bezug auf die porösen Partikel schon definiert. Das Vorliegen von Silicium enthaltenden Materialien in Form von Aggregaten oder Agglomeraten kann beispielsweise mittels herkömmlicher Raster-Elektronen-Mikroskopie (REM) sichtbar gemacht werden.

Das Silicium enthaltende Material kann eine beliebige Morphologie aufweisen, also beispielsweise splittrig, plattig, sphärisch oder auch nadelförmig sein, wobei splittrige oder sphärische Partikel bevorzugt sind.

Gemäß der Definition von Wadell ist die Sphärizität $\psi$ das Verhältnis aus der Oberfläche einer Kugel gleichen Volumens zur tatsächlichen Oberfläche eines Körpers. Im Falle einer Kugel hat $\psi$ den Wert 1. Nach dieser Definition haben die Silicium enthaltenden Materialien eine Sphärizität $\psi$ von vorzugsweise 0,3 bis 1,0 besonders bevorzugt von 0,5 bis 1,0 und am meisten bevorzugt von 0,65 bis 1,0.

Die Sphärizität $S$ ist das Verhältnis aus dem Umfang eines äquivalenten Kreises mit gleicher Fläche A wie die Projektion des auf eine Fläche projizierten Partikels und dem gemessenen Umfang U dieser Projektion:

$$S = 2\sqrt{\pi A}/U$$

. Im Falle eines ideal kreisförmigen Partikels hätte $S$ den Wert 1. Für die Silicium enthaltenden Materialien liegt die Sphärizität $S$ im Bereich von vorzugsweise 0,5 bis 1,0 und besonders bevorzugt von 0,65 bis 1,0, bezogen auf die Perzentile $S_{10}$ bis $S_{90}$ der Sphärizitäts-Anzahlverteilung. Die Messung der Sphärizität $S$ erfolgt beispielsweise anhand von Aufnahmen einzelner Partikel mit einem optischen Mikroskop oder bei Partikeln < 10 $\mu$m bevorzugt mit einem Rasterelektronenmikroskop durch grafische Auswertung mittels einer Bildanalysesoftware, wie beispielsweise ImageJ.

Über die Morphologie, die materielle Zusammensetzung, insbesondere die spezifische Oberfläche oder die innere Porosität des Silicium enthaltenden Materials kann die Zyklisierungsstabilität von Lithium-Ionen-Batterien weiter gesteigert werden.

Das Silicium enthaltende Material enthält bevorzugt 10 bis 90 Gew.-%, mehr bevorzugt 20 bis 80 Gew.-%, besonders bevorzugt 30 bis 60 Gew.-% und insbesondere bevorzugt 40 bis 50 Gew.-% an porösen Partikeln, bezogen auf das Gesamtgewicht des Silicium enthaltenden Materials.

Das Silicium enthaltende Material enthält bevorzugt 10 bis 90 Gew.-%, mehr bevorzugt 20 bis 80 Gew.-%, besonders bevorzugt 30 bis 60 Gew.-% und insbesondere bevorzugt 40 bis 50 Gew.-% über die Abscheidung aus dem Silicium-Präkursor erhaltenes Silicium, bezogen auf das Gesamtgewicht des Silicium enthaltenden Materials (Bestimmung vorzugsweise mittels Elementaranalyse, wie ICP-OES). Falls die porösen Partikel Siliciumverbindungen enthalten, beispielsweise in Form von Siliciumdioxid, lassen sich die vorgenannten Angaben in Gew.-% bestimmen, indem die mittels Elementaranalyse ermittelte Siliciummasse der porösen Partikel von der mittels Elementaranalyse ermittelte Siliciummasse des Silicium enthaltenden Materials subtrahiert wird und das Ergebnis durch die Masse des Silicium enthaltenden Materials dividiert wird.

Das Volumen des im Silicium enthaltenden Material enthaltenen, über die Abscheidung aus dem Silicium-Präkursor erhaltenen Siliciums, ergibt sich aus dem Massenanteil des über die Abscheidung aus dem Silicium-Präkursor erhaltenen Siliciums an der Gesamtmasse des Silicium enthaltenden Materials dividiert durch die Dichte von Silicium (2,336 g/cm$^3$).

Das Porenvolumen P der Silicium enthaltenden Materialien ergibt sich aus der Summe von gaszugänglichem und gasunzugänglichem Porenvolumen. Das gaszugängliche Porenvolumen nach Gurwitsch des Silicium enthaltenden Materials ist bestimmbar durch Gassorptionsmessungen mit Stickstoff nach DIN 66134.

Das gasunzugängliche Porenvolumen des Silicium enthaltenden Materials ist bestimmbar mit der Formel:

Gasunzugängliches Porenvolumen = 1/Reinmaterialdichte - 1/Skelettdichte

Dabei ist die Reinmaterialdichte eines Silicium enthaltenden Materials eine theoretische Dichte, die sich aus der Summe der theoretischen Reinmaterialdichten der im Silicium enthaltenden Material enthaltenen Komponenten, multipliziert mit ihrem jeweiligen Gewichts-bezogenen prozentualen Anteil am Gesamtmaterial, berechnen lässt. Reinmaterialdichten sind in Ceramic Data Portal des National Institute of Standards (NIST, https://srdata.nist.gov/CeramicDataPortal/scd) angegeben. Die Bestimmung der Skelettdichte ist weiter unten am Anfang der Beschreibung der Beispiele beschrieben. Beispielsweise ergibt sich damit für ein Silicium enthaltendes Material:

Reinmaterialdichte = theoretische Reinmaterialdichte des Siliciums * Anteil des Siliciums in Gew.-% + theoretische Reinmaterialdichte der porösen Partikel * Anteil der porösen Partikel in Gew.-%.

Das Porenvolumen P der Silicium enthaltenden Materialien liegt im Bereich von bevorzugt 0 bis 400 Vol.-%, mehr bevorzugt im Bereich von 100 bis 350 Vol.-% und besonders bevorzugt im Bereich von 200 bis 350 Vol.-% bezogen auf das Volumen des im Silicium enthaltenden Material enthaltenen, aus der Abscheidung aus dem Silicium-Präkursor erhaltenen Siliciums.

Die im Silicium enthaltenden Material enthaltene Porosität kann sowohl gaszugänglich als auch gasunzugänglich sein. Das Verhältnis des Volumens von gaszugänglicher zu gasunzugänglicher Porosität des Silicium enthaltenden Materials kann generell im Bereich von 0 (keine gaszugänglichen Poren) bis 1 (alle Poren sind gaszugänglich) liegen. Bevorzugt liegt das Verhältnis des Volumens von gaszugänglicher zu gasunzugänglicher Porosität des Silicium enthaltenden Materials im Bereich von 0 bis 0,8, besonders bevorzugt im Bereich von 0 bis 0,3 und insbesondere bevorzugt von 0 bis 0,1.

Die Poren des Silicium enthaltenden Materials können beliebige Durchmesser aufweisen, beispielsweise im Bereich von Makroporen (> 50 nm), Mesoporen (2 bis 50 nm) und Mikroporen (< 2 nm) liegen. Das Silicium enthaltende Material kann auch beliebige Mischungen verschiedener Porentypen enthalten. Bevorzugt enthält das Silicium enthaltende Material höchstens 30 % Makroporen, bezogen auf das Gesamtporenvolumen, besonders bevorzugt ist ein Silicium enthaltendes Material ohne Makroporen und ganz besonders bevorzugt ist ein Silicium enthaltendes Material mit mindestens 50 % Poren mit einem mittleren Porendurchmesser unter 5 nm. Insbesondere bevorzugt weist das Silicium enthaltende Material ausschließlich Poren mit einem Durchmesser von höchstens 2 nm auf.

Das Silicium enthaltende Material weist Siliciumstrukturen auf, die in mindestens einer Dimension Strukturgrößen von bevorzugt höchstens 1000 nm, mehr bevorzugt kleiner 100 nm, besonders bevorzugt kleiner 5 nm (Bestimmungsmethode: Raster-Elektronen-Mikroskopie (REM) und/oder High-Resolution-Transmissions-Electron-Microscopy (HR-TEM)) aufweisen.

Bevorzugt enthält das Silicium enthaltende Material Siliciumschichten mit einer Schichtdicke unterhalb von 1000 nm, mehr bevorzugt kleiner 100 nm, besonders bevorzugt kleiner 5 nm (Bestimmungsmethode: Raster-Elektronen-Mikroskopie (REM) und/oder High-Resolution-Transmissions-Electron-Microscopy (HR-TEM)).

Das Silicium enthaltende Material kann auch Silicium in Form von Partikeln enthalten. Siliciumpartikel haben einen Durchmesser von bevorzugt höchstens 1000 nm, mehr bevorzugt kleiner 100 nm, besonders bevorzugt kleiner 5 nm (Bestimmungsmethode: Raster-Elektronen-Mikroskopie (REM) und/oder High-Resolution-Transmissions-Electron-Microscopy (HR-TEM)). Die Angabe zu den Siliciumpartikeln bezieht sich hierbei vorzugsweise auf den Durchmesser des Umkreises der Partikel im Mikroskopbild.

Das Silicium enthaltende Material hat eine spezifische Oberfläche von höchstens 50 m$^2$/g, bevorzugt kleiner 30 m$^2$/g, und insbesondere bevorzugt kleiner 10 m$^2$/g. Die BET-Oberfläche wird gemäß DIN 66131 (mit Stickstoff) bestimmt. Damit kann bei Einsatz des Silicium enthaltenden Materials als Aktivmaterial in Anoden für Lithium-Ionen-Batterien die SEI-Bildung reduziert und die initiale Couloumb-Effizienz gesteigert werden.

Ferner kann das aus dem Silicium-Präkursor abgeschiedene Silicium im Silicium enthaltenden Material Dotierstoffe enthalten, beispielsweise ausgewählt aus der Gruppe enthaltend Li, Fe, Al, Cu, Ca, K, Na, S, Cl, Zr, Ti, Pt, Ni, Cr, Sn, Mg, Ag, Co, Zn, B, P, Sb, Pb, Ge, Bi, seltene Erden oder Kombinationen daraus. Bevorzugt sind dabei Li und/oder Sn. Der Gehalt an Dotierstoffen im Silicium enthaltenden Material ist bevorzugt höchstens 1 Gew.-% und besonders bevorzugt höchstens 100 ppm bezogen auf das Gesamtgewicht des Silicium enthaltenden Materials, bestimmbar mittels ICP-OES.

Das Silicium enthaltende Material weist allgemein eine überraschend hohe Stabilität bei Druckbelastung und/oder Scherbelastung auf. Die Druckstabilität und die Scherstabilität des Silicium enthaltenden Materials zeigt sich dabei beispielsweise dadurch, dass das Silicium enthaltende Material bei Druck-(beispielsweise bei der Elektrodenverdichtung) beziehungsweise Scher-Belastung (beispielsweise bei der Elektrodenpräparation) keine oder nur geringfügige Änderungen ihrer porösen Struktur im REM aufweist.

Das Silicium enthaltende Material kann allgemein neben den porösen Partikeln, dem aus dem Silicium-Präkursor abgeschiedenen Silicium und den weiteren zusätzlichen Elementen weitere Komponenten enthalten. Insbesondere kann zusätzlich Kohlenstoff enthalten sein. Insbesondere kann Kohlenstoff in Form von dünnen Schichten mit einer Schichtdicke von höchstens 1 $\mu$m, bevorzugt kleiner 100 nm, besonders bevorzugt kleiner 5 nm und ganz besonders bevorzugt kleiner 1 nm enthalten sein (bestimmbar über REM bzw. HR-TEM). Die Kohlenstoffschichten können beispielsweise auf der Oberfläche der Poren und/oder auf der äußeren Oberfläche des Silicium enthaltenden Materials vorhanden sein. Auch die Reihenfolge verschiedener Schichten im Silicium enthaltenden Material sowie deren Anzahl ist beliebig. So kann auf einem porösen Partikel zunächst eine Schicht eines weiteren Materials, das sich vom Material der porösen Partikel unterscheidet, wie beispielsweise Kohlenstoff, vorhanden sein und darauf eine Siliciumschicht oder eine Schicht von Siliciumpartikeln zugegen sein. Auch kann auf der Siliciumschicht oder auf der Schicht von Siliciumpartikeln wiederum eine Schicht eines weiteren Materials vorhanden sein, welches vom Material der porösen Partikel verschieden oder gleich diesem sein kann, unabhängig davon, ob zwischen dem porösen Partikel und der Siliciumschicht oder der aus Siliciumpartikeln bestehenden Schicht eine weitere Schicht eines von dem Material der porösen Partikel unterschiedlichen Materials vorhanden ist.

Das Silicium enthaltende Material enthält vorzugsweise $\leq$ 50 Gew.-%, besonders bevorzugt $\leq$ 40 Gew.-% und insbesondere bevorzugt $\leq$ 20 Gew.-% an zusätzlichen Elementen. Das Silicium enthaltende Material enthält vorzugsweise $\geq$ 1 Gew.-%, besonders bevorzugt $\geq$ 2 Gew.-% und insbesondere bevorzugt $\geq$ 3 Gew.-% an zusätzlichen Elementen. Die Angaben in Gew.-% beziehen sich auf das Gesamtgewicht des Silicium enthaltenden Materials. In einer alternativen Ausführungsform enthält das Silicium enthaltende Material keine zusätzlichen Elemente.

Ein weiterer Gegenstand der Erfindung ist ein Verfahren zur Herstellung des erfindungsgemäßen Silicium enthaltenden Materials, indem ein oder mehrere Silicium-Präkursoren in Gegenwart von einem oder mehreren porösen Partikeln thermisch zersetzt werden, wodurch in Poren und auf der Oberfläche der porösen Partikel Silicium abgeschieden wird, wobei das Silicium enthaltende Material eine spezifische Oberfläche von höchstens 50 m$^2$/g, bestimmt durch Stickstoff-Sorption und BET-Auswertung, aufweist, dadurch gekennzeichnet, dass poröse Partikel

   a) einen mittleren elektrischen Partikelwiderstand von zumindest 2 kOhm und
   b) eine reversible Delithiierungs-Kapazität $\beta$ von höchstens 100 mAh/g aufweisen,

wobei die porösen Partikel auf einem oder mehreren Materialien basieren, ausgewählt aus der Gruppe enthaltend Oxide, ausgewählt aus der Gruppe enthaltend Siliciumdioxid, Aluminiumoxid, Silicium-Aluminium-Mischoxide, Magnesiumoxid, Bleioxide und Zirkoniumoxid, Carbide, ausgewählt aus der Gruppe enthaltend Siliciumcarbide und Borcarbide, Nitride, ausgewählt aus der Gruppe enthaltend Siliciumnitride und Bornitride, sowie keramische Werkstoffe.

Die Herstellung des Silicium enthaltenden Materials kann in beliebigen, für die Abscheidung von Silicium aus Silicium-Präkursoren gängigen Reaktoren erfolgen. Bevorzugt sind Reaktoren ausgewählt aus der Gruppe umfassend Wirbelschichtreaktoren, Drehrohröfen, welche in beliebiger, von horizontaler bis hin zu vertikaler Anordnung ausgerichtet sein können, und Festbett-Reaktoren, welche als offene oder geschlossene Systeme, beispielsweise als Druckreaktoren, betrieben werden können. Besonders bevorzugt sind Reaktoren, welche eine homogene Durchmischung der porösen Partikel sowie des während der Abscheidung entstehenden Silicium enthaltenden Materials mit den Silicium-Präkursoren ermöglichen. Dies ist vorteilhaft für eine möglichst homogene Abscheidung von Silicium in Poren und auf der Oberfläche der porösen Partikel. Am meisten bevorzugte Reaktoren sind Wirbelschichtreaktoren, Drehrohröfen oder Druckreaktoren, insbesondere Wirbelschichtreaktoren oder Druckreaktoren.

Aus den Silicium-Präkursoren wird unter thermischer Zersetzung allgemein Silicium abgeschieden. Bevorzugte Silicium-Präkursoren werden ausgewählt aus der Gruppe umfassend Silicium-Wasserstoff-Verbindungen, wie Monosilan SiH$_4$, Disilan Si$_2$H$_6$ sowie höhere lineare, verzweigte oder auch zyklische Homologe, neo-Pentasilan Si$_5$H$_{12}$, cyclo-Hexasilan Si$_6$H$_{12}$; Chlor-haltige Silane, wie Trichlorsilan HSiCl$_3$, Dichlorsilan H$_2$SiCl$_2$, Chlorsilan H$_3$SiCl, Tetrachlorsilan SiCl$_4$, Hexachlordisilan Si$_2$Cl$_6$, sowie höhere lineare, verzweigte oder auch cyclische Homologe wie beispielsweise 1,1,2,2-Tetrachlordisilan Cl$_2$HSi-SiHCl$_2$; chlorierte und teilchlorierte Oligo- und Polysilane, Methylchlorsilane, wie Trichlormethylsilan MeSiCl$_3$, Dichlordimethylsilan Me$_2$SiCl$_2$, Chlortrimethylsilan Me$_3$SiCl, Tetramethylsilan Me$_4$Si, Dichlormethylsilan MeHSiCl$_2$, Chlormethylsilan MeH$_2$SiCl, Methylsilan MeH$_3$Si, Chlordimethylsilan Me$_2$HSiCl, Dimethylsilan Me$_2$H$_2$Si, Trimethylsilan Me$_3$SiH oder auch Mischungen aus den beschriebenen Siliciumverbindungen. Insbesondere sind Silicium-Präkursoren ausgewählt aus der Gruppe umfassend Monosilan SiH$_4$, Disilan Si$_2$H$_6$, Trichlorsilan HSiCl$_3$, Dichlorsilan H$_2$SiCl$_2$, Chlorsilan H$_3$SiCl, Tetrachlorsilan SiCl$_4$, Hexachlordisilan Si$_2$Cl$_6$ und Mischungen enthaltend diese Silane.

Des Weiteren können ein oder mehrere reaktive Bestandteile in den Reaktor eingebracht werden. Beispiele hierfür sind Dotierstoffe auf Basis von Bor, Stickstoff, Phosphor, Arsen, Germanium, Eisen oder auch Nickel enthaltender Verbindungen. Die Dotierstoffe werden bevorzugt ausgewählt aus der Gruppe umfassend Ammoniak NH$_3$, Diboran B$_2$H$_6$, Phosphan PH$_3$, German GeH$_4$, Arsan AsH$_3$ und Nickeltetracarbonyl Ni(CO)$_4$.

Weitere Beispiele für reaktive Bestandteile sind Wasserstoff oder auch Kohlenwasserstoffe, insbesondere ausgewählt aus der Gruppe umfassend aliphatische Kohlenwasserstoffe mit 1 bis 10 Kohlenstoffatomen, bevorzugt 1 bis 6 Kohlenstoffatomen, wie Methan, Ethan, Propan, Butan, Pentan, Isobutan, Hexan, Cyclopropan, Cyclobutan, Cyclopentan, Cyclohexan, Cycloheptan; ungesättigte Kohlenwasserstoffe mit 1 bis 10 Kohlenstoffatomen wie Ethylen, Acetylen, Propylen oder Butylen; Isopren, Butadien, Divinylbenzol, Vinylacetylen, Cyclohexadien, Cyclooctadien; zyklische ungesättigte Kohlenwasserstoffe wie Cyclopropen, Cyclobuten, Cyclopenten, Cyclohexen, Cyclohexadien, Cyclopentadien, Dicyclopentadien und Norbornadien, aromatische Kohlenwasserstoffe wie Benzol, Toluol, p-,m-,o-Xylol, Styrol (Vinylbenzol), Ethylbenzol, Diphenylmethan oder Naphthalin; weitere aromatische Kohlenwasserstoffe wie Phenol, o-, m-, p-Kresol, Cymol, Nitrobenzol, Chlorbenzol, Pyridin, Anthracen und Phenanthren, Myrcen, Geraniol, Thioterpineol, Norbornan, Borneol, iso-Borneol, Bornan, Campher, Limonen, Terpinen, Pinen, Pinan, Caren, Phenol, Anilin, Anisol, Furan, Furfural, Furfurylalkohol, Hydroxymethylfurfural, Bishydroxymethylfuran und gemischte Fraktionen, die eine Vielzahl solcher Verbindungen enthalten, beispielsweise aus Erdgaskondensaten, Erdöldestillaten, Koksofenkondensaten, gemischte Fraktionen aus den Produktströmen eines Fluid-Catalytic-Crackers (FCC), Steam-Crackers oder einer Fischer-Tropsch-Syntheseanlage, oder ganz allgemein kohlenwasserstoffhaltige Stoffströme aus der Holz-, Erdgas-, Erdöl- und Kohleverarbeitung.

Das Verfahren wird vorzugsweise in Inertgas-Atmosphäre durchgeführt, beispielsweise in Stickstoff- oder Argon-Atmosphäre.

Im Übrigen kann das Verfahren auf herkömmliche Weise ausgeführt werden, wie es zur Abscheidung von Silicium aus Silicium-Präkursoren gängig ist, erforderlichenfalls mit für den Fachmann üblichen Routineanpassungen.

Ein weiterer Gegenstand der Erfindung ist die Verwendung des erfindungsgemäßen Silicium enthaltenden Materials als Aktivmaterial in Anodenmaterialien für Anoden von Lithium-Ionen-Batterien sowie die Verwendung der erfindungsgemäßen Anoden zur Herstellung von Lithium-Ionen-Batterien.

Das Anodenmaterial basiert vorzugsweise auf einer Mischung umfassend das erfindungsgemäße Silicium enthaltende Material, ein oder mehrere Bindemittel, gegebenenfalls Graphit als weiteres Aktivmaterial, gegebenenfalls ein oder mehrere weitere elektrisch leitende Komponenten und gegebenenfalls ein oder mehrere Additive.

Ein weiterer Gegenstand der Erfindung ist ein Anodenmaterial enthaltend das erfindungsgemäße Silicium enthaltende Material, ein oder mehrere Bindemittel, gegebenenfalls Graphit als weiteres Aktivmaterial, gegebenenfalls ein oder mehrere weitere elektrisch leitende Komponenten und gegebenenfalls ein oder mehrere Additive.

Durch Einsatz von weiteren elektrisch leitenden Komponenten im Anodenmaterial können die Übergangswiderstände innerhalb der Elektrode sowie zwischen Elektrode und Stromableiter reduziert werden, was die Strombelastbarkeit der Lithium-Ionen-Batterie verbessert. Bevorzugte weitere elektrisch leitende Komponenten sind Leitruß, Kohlenstoff-Nanoröhrchen oder metallische Partikel, beispielsweise Kupfer.

Die Primärpartikel von Leitruß haben vorzugsweise eine volumengewichtete Partikelgrößenverteilung zwischen den Durchmesser-Perzentilen $d_{10} = 5$ nm und $d_{90} = 200$ nm. Die Primärpartikel von Leitruß können auch kettenartig verzweigt sein und bis zu μm-große Strukturen bilden. Kohlenstoff-Nanoröhrchen haben vorzugsweise Durchmesser von 0,4 bis 200 nm, besonders bevorzugt 2 bis 100 nm und am meisten bevorzugt 5 bis 30 nm. Die metallischen Partikel haben eine volumengewichtete Partikelgrößenverteilung, die zwischen den Durchmesser-Perzentilen $d_{10} = 5$ nm und $d_{90} = 800$ nm liegt.

Das Anodenmaterial enthält vorzugsweise 0 bis 95 Gew.-%, besonders bevorzugt 0 bis 40 Gew.-% und am meisten bevorzugt 0 bis 25 Gew.-% an einer oder mehreren weiteren elektrisch leitenden Komponenten, bezogen auf das Gesamtgewicht des Anodenmaterials.

Das Silicium enthaltende Material kann in den Anoden für Lithium-Ionen-Batterien zu vorzugsweise 5 bis 100 Gew.-%, besonders bevorzugt 30 bis 100 Gew.-% und am meisten bevorzugt 60 bis 100 Gew.-%, bezogen auf das gesamte im Anodenmaterial enthaltene Aktivmaterial, enthalten sein.

Bevorzugte Bindemittel sind Polyacrylsäure oder deren Alkali-, insbesondere Lithium- oder Natrium-Salze, Polyvinylalkohole, Cellulose oder Cellulosederivate, Polyvinylidenfluorid, Polytetrafluorethylen, Polyolefine, Polyimide, insbesondere Polyamidimide, oder thermoplastische Elastomere, insbesondere Ethylen-Propylen-Dien-Terpolymere. Besonders bevorzugt sind Polyacrylsäure, Polymethacrylsäure oder Cellulose-Derivate, insbesondere Carboxymethylcellulose. Besonders bevorzugt sind auch die Alkali-, insbesondere Lithium- oder Natrium-Salze, der vorgenannten Bindemittel. Am meisten bevorzugt sind die Alkali-Salze, insbesondere Lithium- oder Natrium-Salze, der Polyacrylsäure oder der Polymethacrylsäure. Es können sämtliche oder vorzugsweise ein Anteil der Säure-Gruppen eines Bindemittels in Form von Salzen vorliegen. Die Bindemittel haben eine Molmasse von vorzugsweise 100.000 bis 1.000.000 g/mol. Es können auch Gemische von zwei oder mehr Bindemitteln eingesetzt werden.

Als Graphit kann allgemein natürlicher oder synthetischer Graphit eingesetzt werden. Die Graphitpartikel haben bevorzugt eine volumengewichtete Partikelgrößenverteilung zwischen den Durchmesser-Perzentilen $d_{10} > 0,2$ μm und $d_{90} < 200$ μm.

Beispiele für Additive sind Porenbildner, Dispergiermittel, Verlaufsmittel oder Dotiermittel, beispielsweise elementares Lithium.

Bevorzugte Rezepturen für das Anodenmaterial enthalten vorzugsweise 5 bis 95 Gew.-%, insbesondere 60 bis 90 Gew.-% des Silicium enthaltenden Materials; 0 bis 90 Gew.-%, insbesondere 0 bis 40 Gew.-% weitere elektrisch leitende Komponenten; 0 bis 90 Gew.-%, insbesondere 5 bis 40 Gew.-% Graphit; 0 bis 25 Gew.-%, insbesondere 5 bis 20 Gew.-% Bindemittel; und gegebenenfalls 0 bis 80 Gew.-%, insbesondere 0,1 bis 5 Gew.-% weitere Additive, wobei sich die Angaben in Gew.-% auf das Gesamtgewicht des Anodenmaterials beziehen und sich die Anteile aller Bestandteile des Anodenmaterials auf 100 Gew.-% aufsummieren.

Ein weiterer Gegenstand der Erfindung ist eine Anode, die einen Stromableiter umfasst, der mit dem erfindungsgemäßen Anodenmaterial beschichtet ist. Die Anode wird vorzugsweise in Lithium-Ionen-Batterien verwendet.

Die Verarbeitung der Bestandteile des Anodenmaterials zu einer Anodentinte bzw. -paste kann beispielsweise in einem Lösungsmittel, vorzugsweise ausgewählt aus der Gruppe umfassend Wasser, Hexan, Toluol, Tetrahydrofuran, N-Methylpyrrolidon, N-Ethylpyrrolidon, Aceton, Ethylacetat, Dimethylsulfoxid, Dimethylacetamid und Ethanol sowie Gemischen dieser Lösungsmittel, vorzugsweise unter Verwendung von Rotor-Stator-Maschinen, Hochenergiemühlen, Planetenknetern, Rührwerkskugelmühlen, Rüttelplatten oder Ultraschallgeräten erfolgen.

Die Anodentinte bzw. -paste weist einen pH-Wert von vorzugsweise 2 bis 7,5 (bestimmt bei 20°C, beispielsweise mit dem pH-Meter von WTW pH 340i mit Sonde SenTix RJD) auf.

Die Anodentinte oder -paste kann beispielsweise auf eine Kupferfolie oder einen anderen Stromsammler aufgerakelt werden. Andere Beschichtungsverfahren, wie beispielsweise Rotationsbeschichtung (Spin-Coating), Rollen-, Tauch- oder Schlitzdüsenbeschichtung, Streichen oder Sprühen, können ebenso erfindungsgemäß verwendet werden.

Vor dem Beschichten der Kupferfolie mit dem erfindungsgemäßen Anodenmaterial kann eine Behandlung der Kupferfolie mit einem handelsüblichen Primer, beispielsweise auf der Basis von Polymerharzen oder Silanen erfolgen. Primer können zu einer Verbesserung der Haftung auf dem Kupfer führen, besitzen aber selbst im Allgemeinen praktisch keine elektrochemische Aktivität.

Das Anodenmaterial wird vorzugsweise bis zur Gewichtskonstanz getrocknet. Die Trocknungstemperatur richtet sich nach den eingesetzten Komponenten und dem verwendeten Lösungsmittel. Sie liegt bevorzugt zwischen 20°C und 300°C, besonders bevorzugt zwischen 50°C und 150°C.

Die Schichtdicke, das heißt die Trockenschichtdicke der Anodenbeschichtung, ist bevorzugt 2 $\mu$m bis 500 $\mu$m, besonders bevorzugt von 10 $\mu$m bis 300 $\mu$m.

Abschließend können die Elektrodenbeschichtungen kalandriert werden, um eine definierte Porosität einzustellen. Die so hergestellten Elektroden weisen bevorzugt Porositäten von 15 bis 85% auf, welche über Quecksilberporosimetrie nach DIN ISO 15901-1 bestimmt werden können. Dabei werden bevorzugt 25 bis 85% des so bestimmbaren Porenvolumens durch Poren bereitgestellt, welche einen Porendurchmesser von 0,01 bis 2 $\mu$m aufweisen.

Ein weiterer Gegenstand der Erfindung sind Lithium-Ionen-Batterien umfassend eine Kathode, eine Anode, zwei elektrisch leitende Anschlüsse an den Elektroden, einen Separator und einen Elektrolyten, mit dem der Separator und die beiden Elektroden getränkt sind, sowie ein die genannten Teile aufnehmendes Gehäuse, dadurch gekennzeichnet, dass die Anode erfindungsgemäßes Silicium enthaltendes Material enthält.

In Sinne dieser Erfindung umfasst der Begriff Lithium-Ionen-Batterie auch Zellen. Zellen umfassen allgemein eine Kathode, eine Anode, einen Separator und einen Elektrolyten. Lithium-Ionen-Batterien enthalten neben einer oder mehreren Zellen vorzugsweise zusätzlich ein Batteriemanagementsystem. Batteriemanagementsysteme dienen allgemein zur Steuerung von Batterien, beispielsweise mittels elektronischer Schaltungen, insbesondere zur Erkennung des Ladezustands, für den Tiefentladeschutz oder Überladeschutz.

Als bevorzugte Kathodenmaterialien können Lithiumcobaltoxid, Lithiumnickeloxid, Lithiumnickelcobaltoxid (dotiert oder nicht dotiert), Lithiummanganoxid (Spinell), Lithiumnickelcobaltmanganoxide, Lithiumnickelmanganoxide, Lithiumeisenphosphat, Lithiumcobaltphosphat, Lithiummanganphosphat, Lithiumvanadiumphosphat oder Lithiumvanadiumoxide eingesetzt werden.

Der Separator ist vorzugsweise eine elektrisch isolierende, für Ionen durchlässige Membran, bevorzugt aus Polyolefinen, beispielsweise Polyethylen (PE) oder Polypropylen (PP), oder Polyester bzw. entsprechenden Laminaten. Der Separator kann wie in der Batterieherstellung gebräuchlich alternativ aus Glas- oder Keramikmaterialien bestehen oder damit beschichtet sein. Der Separator trennt bekanntermaßen die erste Elektrode von der zweiten Elektrode und verhindert somit elektronisch leitende Verbindungen zwischen den Elektroden (Kurzschluss).

Der Elektrolyt ist vorzugsweise eine Lösung enthaltend ein oder mehrere Lithiumsalze (= Leitsalz) in einem aprotischen Lösungsmittel. Bevorzugt sind Leitsalze ausgewählt aus der Gruppe enthaltend Lithiumhexafluorophosphat, Lithiumhexafluoroarsenat, Lithiumperchlorat, Lithiumtetrafluoroborat, Lithiumimide, Lithiummethide, LiCF$_3$SO$_3$, LiN(CF$_3$SO$_2$) und Lithiumborate. Die Konzentration des Leitsalzes, bezogen auf das Lösungsmittel, liegt vorzugsweise zwischen 0,5 mol/l und der Löslichkeitsgrenze des entsprechenden Salzes. Besonders bevorzugt beträgt sie 0,8 bis 1,2 mol/l.

Als Lösungsmittel können beispielsweise cyclische Carbonate, Propylencarbonat, Ethylencarbonat, Fluorethylencarbonat, Dimethylcarbonat, Diethylcarbonat, Ethylmethylcarbonat, Dimethoxyethan, Diethoxyethan, Tetrahydrofuran, 2-Methyltetrahydrofuran, gamma-Butyrolacton, Dioxolan, Acetonitril, organische Kohlensäureester oder Nitrile, einzeln oder als Mischungen daraus, eingesetzt werden.

Bevorzugt enthält der Elektrolyt einen Filmbildner, wie beispielsweise Vinylencarbonat oder Fluorethylencarbonat. Dadurch kann eine signifikante Verbesserung der Zyklenfestigkeit der Anoden enthaltend das erfindungsgemäße Silicium enthaltende Material erreicht werden. Dies wird hauptsächlich der Bildung einer festen Elektrolytzwischenphase auf der Oberfläche von aktiven Partikeln zugeschrieben. Der Anteil des Filmbildners im Elektrolyten beträgt bevorzugt zwischen 0,1 und 20,0 Gew.-%, besonders bevorzugt zwischen 0,2 und 15,0 Gew.-% und am meisten bevorzugt zwischen 0,5 und 10 Gew.-%.

Um die faktischen Kapazitäten der Elektroden einer Lithium-Ionen-Zelle möglichst optimal aufeinander abzustimmen, ist es vorteilhaft, die Materialien für die positive und negative Elektrode mengenmäßig auszubalancieren. Von besonderer Bedeutung ist in diesem Zusammenhang, dass es beim ersten bzw. initialen Lade-/Entladezyklus von sekundären Lithium-Ionen-Zellen (der sogenannten Formierung) zur Ausbildung einer Deckschicht auf der Oberfläche der elektrochemisch aktiven Materialien in der Anode kommt. Diese Deckschicht wird als "Solid Elektrolyte Interphase" (SEI) bezeichnet und besteht in der Regel vor allem aus Elektrolytzersetzungsprodukten sowie einer gewissen Menge an Lithium, das entsprechend für weitere Lade-/Entladereaktionen nicht mehr zur Verfügung steht. Die Dicke und Zusammensetzung der SEI ist abhängig von der Art und der Qualität des verwendeten Anodenmaterials und der verwendeten Elektrolytlösung.

Die SEI ist im Falle von Graphit besonders dünn. Auf Graphit kommt es im ersten Ladeschritt zu einem Verlust von üblicherweise 5% bis 35% des mobilen Lithiums in der Zelle. Dementsprechend sinkt auch die reversible Kapazität der Batterie.

Bei Anoden mit dem erfindungsgemäßen Silicium enthaltenden Material kommt es im ersten Ladeschritt zu einem Verlust an mobilem Lithium von vorzugsweise höchstens 30%, besonders bevorzugt höchstens 20% und am meisten bevorzugt höchstens 10%, was deutlich unter den beispielsweise in der US 10,147,950 B1 für Silicium-haltige Kompositanodenmaterialien beschriebenen Werten des Stands der Technik liegt.

Die erfindungsgemäße Lithium-Ionen-Batterie kann in allen üblichen Formen, beispielsweise in gewickelter, gefalteter oder gestapelter Form hergestellt werden.

Alle zur Herstellung der erfindungsgemäßen Lithium-Ionen-Batterie, wie oben beschrieben, benutzten Stoffe und Materialien sind bekannt. Die Herstellung der Teile der erfindungsgemäßen Batterie und ihre Zusammenfügung zur erfindungsgemäßen Batterie erfolgt nach den auf dem Gebiet der Batterieherstellung bekannten Verfahren.

Das erfindungsgemäße Silicium enthaltende Material zeichnet sich durch ein deutlich verbessertes elektrochemisches Verhalten aus und führt zu Lithium-Ionen-Batterien mit hohen volumetrischen Kapazitäten und hervorragenden Anwendungseigenschaften. Das erfindungsgemäße Silicium enthaltende Material ist permeabel für Lithiumionen und Elektronen und ermöglicht somit den Ladungstransport. Die Menge an SEI in Lithiumionen-Batterien kann mit dem erfindungsgemäßen Silicium enthaltenden Material in großem Umfang reduziert werden. Zusätzlich löst sich die SEI aufgrund des Designs des erfindungsgemäßen Silicium enthaltenden Materials nicht mehr oder zumindest in weit geringerem Umfang von der Oberfläche des erfindungsgemäßen Silicium enthaltenden Materials ab. All dies führt zu einer hohen Zyklenbeständigkeit entsprechender Lithiumionen-Batterien. Das Fading und Trapping können minimiert werden. Darüber hinaus zeigen erfindungsgemäße Lithium-Ionen-Batterien einen geringen initialen und kontinuierlichen Verlust an in der Zelle verfügbarem Lithium und damit hohe Coulomb-Effizienzen.

Die nachfolgenden Beispiele dienen zur weiteren Erläuterung der hier beschriebenen Erfindung.

Rasterelektronemikroskopie (REM/ EDX):

Die mikroskopischen Untersuchungen wurden mit einem Rasterelektronenmikroskop Zeiss Ultra 55 und einem energiedispersem Röntgenspektrometer Oxford X-Max 80N durchgeführt. Die Proben wurden vor der Untersuchung zur Verhinderung von Aufladungsphänomenen mit einer Safematic Compact Coating Unit 010/HV mit Kohlenstoff bedampft. Querschnitte der Silicium enthaltenden Materialien wurden mit einem Ionencutter Leica TIC 3X bei 6 kV erzeugt.

Anorganische Analytik/Elementaranalyse:

Die C-Gehalte wurden mit einem Leco CS 230 Analysator ermittelt, zur Bestimmung von Sauerstoff- und Stickstoff-Gehalten wurde ein Leco TCH-600 Analysator eingesetzt. Die qualitative und quantitative Bestimmung von anderen Elementen erfolgte mittels ICP (inductively coupled plasma)-Emissionsspektrometrie (Optima 7300 DV, Fa. Perkin Elmer). Die Proben wurden dazu in einer Mikrowelle (Microwave 3000, Fa. Anton Paar) sauer aufgeschlossen (HF/HNO$_3$). Die ICP-OES-Bestimmung orientiert sich an der ISO 11885 "Wasserbeschaffenheit - Bestimmung von ausgewählten Elementen durch induktiv gekoppelte Plasma-Atom-Emissionsspektrometrie (ICP-OES) (ISO 11885:2007); Deutsche Fassung EN ISO 11885:2009", die zur Untersuchung saurer, wässriger Lösungen eingesetzt wird (beispielsweise angesäuerte Trinkwasser-, Abwasser- und andere Wasserproben, Königswasserextrakte von Böden und Sedimenten).

Partikelgrößenbestimmung:

Die Bestimmung der Partikelgrößenverteilung erfolgte nach ISO 13320 mittels statischer Laserstreuung mit einem Horiba LA 950. Dabei muss bei der Vorbereitung der Proben besondere Sorgfalt auf die Dispergierung der Partikel in der Messlösung aufgewendet werden, um statt Einzelpartikel nicht die Größe von Agglomeraten zu messen. Für die hier untersuchten Materialien wurden diese in Ethanol dispergiert. Dazu wurde die Dispersion vor der Messung bei Bedarf 4 Minuten in einem Hielscher Ultraschall-Laborgerät Modell UIS250v mit Sonotrode LS24d5 mit 250 W Ultraschall behandelt.

Oberflächenmessung nach BET:

Die spezifische Oberfläche der Materialien wurde über Gasadsorption mit Stickstoff mit einem Gerät Sorptomatic 199090 (Porotec) oder Gerät SA-9603MP (Horiba) nach der BET-Methode gemessen (Bestimmung nach DIN ISO 9277:2003-05 mit Stickstoff).

Skelettdichte:

Die Skelettdichte, das heißt die Dichte des porösen Festkörpers basierend auf dem Volumen ausschließlich der von außen gaszugänglichen Porenräume, wurde mittels Heliumpyknometrie gemäß DIN 66137-2 bestimmt.

Gaszugängliches Porenvolumen:

Das gaszugängliche Porenvolumen nach Gurwitsch wurde durch Gassorptionmessungen mit Stickstoff gemäß DIN 66134 bestimmt.

Bestimmung der reversiblen Delithiierungs-Kapazität $\beta$:

Die Kapazitätsbestimmung der porösen Partikel beziehungsweise der Silicium enthaltenden Materialien wird in einer Knopf-Halbzelle durchgeführt (Typ CR2032, Hohsen Corp.). Dazu wird eine Elektrode aus den porösen Partikeln beziehungsweise dem Silicium enthaltenden Material sowie Bindemittel, gegebenenfalls Graphit, gegebenenfalls weiteren elektrisch leitenden Komponenten und gegebenenfalls Additiven hergestellt und gegen eine Lithium-Gegenelektrode (Rockwood Lithium, Dicke 0,5 mm, Dm = 15 mm) verbaut. Die Arbeitselektrode basierend auf dem Silicium enthaltenden Material entspricht in diesem Zellaufbau der positiven Elektrode. Als Gegenelektrode, welche die negative Elektrode darstellt, wird metallisches Lithium eingesetzt. Ein mit 120 $\mu$l Elektrolyt getränktes, Glasfaser-Filterpapier (Whatman, GD Type D) wird als Separator (Dm = 16 mm) verwendet. Als Elektrolyt wird eine 1,0-molare Lösung von Lithiumhexafluorophosphat in einem 1:4 (v/v) Gemisch von Fluorethylencarbonat und Diethylcarbonat eingesetzt. Der Bau der Zelle erfolgt im Allgemeinen in einer Glovebox (< 1 ppm an $H_2O$ und $O_2$). Der Wassergehalt der Trockenmasse aller Einsatzstoffe liegt vorzugsweise unterhalb von 20 ppm.
Zuerst wird die Halbzelle in den entladenen Zustand überführt, indem sie nach dem cc-Verfahren (**c**onstant **c**urrent) mit konstantem Strom, welcher einer Rate von C/25 bezogen auf die theoretische Kapazität des Silicium enthaltenen Materials entspricht (theoretische Kapazität: Gew.-% Silicium * 3579 mAh/g; Rate: C/25 entspricht einer Ladung/Entladung über einen Zeitraum von 25 h), bis zum Erreichen der Spannungsgrenze von 0,005 V entladen wird. Hierbei wird das Aktivmaterial lithiiert.
Die reversible Delithiierungs-Kapazität $\beta$ der Anodenbeschichtung wird bestimmt durch das anschließende Laden der so hergestellten und entladenen Knopf-Halbzelle mit C/25 bis Erreichen der Spannungsgrenze von 1,5 V.
Die elektrochemischen Messungen werden bei 20°C durchgeführt.

Bestimmung des mittleren elektrischen Partikelwiderstands:

Zur Messung des elektrischen Widerstands von einzelnen Partikeln kleiner 100 $\mu$m wurde ein Shimadzu Mikrocompression Tester MCT211 mit einem flachen Indenter aus Kupfer ausgerüstet, der zusammen mit dem Probenhalter an ein Dual Sourcemeter KEITHLEY 2602 angeschlossen wurde. Die Widerstandswerte der Einzelpartikel streuen aufgrund der unterschiedlichen Geometrie der verschiedenen Partikel. Deshalb wird für jede Produktcharge der Mittelwert des elektrischen Widerstands von mindestens 20 Einzelpartikeln bestimmt. Die statistische Analyse mit einem t-Test [Einstichproben-Test, Student: The Probable Error of a Mean. In: Biometrika. Band 6, Nr. 1 März 1908, S: 1-259] ermöglicht dann bei einem definierten Vertrauensniveau von beispielsweise 95% signifikante Unterschiede zwischen den Mittelwerten von verschiedenen Produktchargen festzustellen.

Beispiel 1:

poröse Partikel aus Siliciumdioxid:

493 ml Ethanol und 308 ml Wasser wurden in einer 1 l Duranglasflasche mit Weithals vorgelegt. Zu dieser Mischung wurden bei Raumtemperatur 30,18 g Tetraethoxysilan (TEOS) zugegeben und unter Rühren gelöst. Die Lösung wurde auf 15°C temperiert und über einen Zeitraum von 45 min mittels Tropftrichter mit weiteren 30,18 g TEOS versetzt. Die Lösung trübte sich dabei langsam ein, wodurch ein Niederschlag erhalten wurde. Die Reaktionsmischung wurde weitere 4 h bei 15°C gerührt. Anschließend wurde der Niederschlag abgenutscht und viermal mit Wasser und Ethanol gewaschen. Das so erhaltene weiße Pulver wurde für 4 h bei 80°C in einem Trockenschrank getrocknet. Das Rohprodukt (18,68 g) wurde in einem Schiffchen in einem Rohrofen mit einer Heizrate von 2°C/min auf 400°C aufgeheizt. Die nächste Haltestufe von 600°C wurde mit 10°C/min angefahren und für 4 h gehalten. Die Atmosphäre des Ofens wurde über einen Argondurchfluss von 12 l/h während der gesamten Reaktion und 3 l/h während der Abkühlphase bis zum Entleeren des Rohres eingestellt. Es wurden 13,74 g (73,6%) poröse $SiO_2$-Partikel erhalten.

Reversible Delithiierungskapazität $\beta$: 8 mAh/g
BET: 1270 m$^2$/g
Partikelgrößenverteilung (PGV): $D_{50}$=5,4 $\mu$m, Spanne 0,77
Gesamtporenvolumen: 0,8 cm$^3$/g
Mittlerer elektrischer Partikelwiderstand: 240000 kOhm

Beispiel 2:

Silicium enthaltendes Material:

Ein Rohrreaktor wurde mit 3,0 g der porösen Siliciumdioxid-Partikel (spez. Oberfläche = 1070 m$^2$/g, Porenvolumen = 0,6 cm$^3$/g) aus Beispiel 1 in einem Quarzglasschiffchen beladen. Nach Inertisierung mit Stickstoff wurde der Reaktor auf 410°C erhitzt. Bei Erreichen der Reaktionstemperatur wurde das Reaktivgas (10% $SiH_4$ in $N_2$, 10 Nl/h) für 5,8 h durch den Reaktor geleitet. Der Reaktor wurde anschließend mit Inertgas gespült, bevor das Produkt bei 500°C für 1 h getempert wurde. Vor der Entnahme aus dem Reaktor wurde das Produkt unter Inertgas auf Raumtemperatur abgekühlt.

BET-Oberfläche: 29 m$^2$/g
PGV: $D_{50}$=5,4 $\mu$m, Spanne 0,77
abgeschiedener Si-Gehalt: 35 Gew.-%
Reversible Delithiierungskapazität $\beta$: 1245 mAh/g
Initiale Coulomb-Effizienz: 92%

Vergleichsbeispiel 3:

Silicium enthaltendes Material:

Ein Rohrreaktor wurde mit 3,0 g einer mesoporösen Siliciumdioxid-Matrix (spez. Oberfläche = 360 m$^2$/g, Porenvolumen = 1,1 cm$^3$/g, Polygoprep™ 100-12 von Macherey-Nagel, mittlerer elektrischer Partikelwiderstand 210000 kOhm, reversible Kapazität $\beta$ = 8 mAh/g) beladen. Nach Inertisierung mit Stickstoff wurde der Reaktor auf 410°C erhitzt. Bei Erreichen der Reaktionstemperatur wurde das Reaktivgas (10% $SiH_4$ in $N_2$, 10 Nl/h) für 5 h durch den Reaktor geleitet. Der Reaktor wurde anschließend mit Inertgas gespült bevor das Produkt bei 500°C für 1 h getempert wurde. Vor der Entnahme aus dem Reaktor kühlte das Produkt unter Inertgas auf Raumtemperatur ab.

BET: 214 m$^2$/g
PGV: $D_{50}$=14 $\mu$m, Spanne 0,8
abgeschiedener Si-Gehalt: 30 Gew.-%
Reversible Delithiierungskapazität $\beta$: 1068 mAh/g
Initiale Coulomb-Effizienz: 89%

Beispiel 4:

Anode enthaltend Silicium enthaltendes Material aus Beispiel 2 und elektrochemische Testung in einer Lithium-Ionen-Batterie:

29,71 g Polyacrylsäure (bei 85°C bis zur Gewichtskonstanz getrocknet; Sigma-Aldrich, Mw ~450.000 g/mol) und 756,60 g deionisiertes Wasser wurden mittels Schüttler (290 1/min) für 2,5 h bis zur vollständigen Lösung der Polyacrylsäure bewegt. Zu der Lösung wurde Lithiumhydroxid Monohydrat (Sigma-Aldrich) portionsweise hinzugegeben, bis der pH-Wert bei 7,0 lag (gemessen mit pH-Meter WTW pH 340i und Sonde SenTix RJD). Die Lösung wurde anschließend mittels Schüttler weitere 4 h durchmischt. 3,87 g der neutralisierten Polyacrylsäure-Lösung und 0,96 g Graphit (Imerys, KS6L C) wurden in einem 50 ml Gefäß vorgelegt und in einem Planetenmischer (SpeedMixer, DAC 150 SP) bei 2000 rpm vermengt. Anschließend wurden 3,40 g des erfindungsgemäßen Silicium enthaltenden Materials aus Beispiel 2 bei 2000 rpm für 1 min untergerührt. Anschließend wurden 1,21 g einer 8 prozentigen Leitrußdispersion und 0,8 g deionisiertes Wasser zugegeben und bei 2000 rpm am Planetenmischer eingearbeitet. Anschließend erfolgte die Dispergierung am Dissolver für 30 min bei 3000 rpm unter konstanten 20°C. Die Entgasung der Tinte erfolgte wieder im Planetenmischer bei 2500 rpm für 5 min unter Vakuum.

Die fertige Dispersion wurde nun mittels eines Filmziehrahmens mit 0,1 mm Spalthöhe (Erichsen, Modell 360) auf eine Kupferfolie mit einer Dicke von 0,03 mm (Schlenk Metallfolien, SE-Cu58) aufgebracht. Die so hergestellte Anodenbeschichtung wurde anschließend 60 min bei 50°C und 1 bar Luftdruck getrocknet. Das mittlere Flächengewicht der trockenen Anodenbeschichtung betrug 3,0 mg/cm$^2$ und die Beschichtungsdichte 0,7 g/cm$^3$.

Die elektrochemischen Untersuchungen wurden an einer Knopfzelle (Typ CR2032, Hohsen Corp.) in 2-Elektroden-Anordnung durchgeführt. Die Elektrodenbeschichtung wurde als Gegenelektrode bzw. negative Elektrode (Dm = 15 mm) eingesetzt, eine Beschichtung auf Basis von Lithium-Nickel-Mangan-Kobaltoxid 6:2:2 mit Gehalt von 94,0% und mittlerem Flächengewicht von 15,9 mg/cm$^2$ (bezogen von der Firma SEI) als Arbeitselektrode bzw. positive Elektrode (Dm = 15 mm) verwendet. Ein mit 60 $\mu$l Elektrolyt getränktes, Glasfaser-Filterpapier (Whatman, GD Type D) diente als Separator (Dm = 16 mm). Der verwendete Elektrolyt bestand aus einer 1,0-molaren Lösung von Lithiumhexafluorophosphat in einem 1:4 (v/v) Gemisch von Fluorethylencarbonat und Diethylcarbonat. Der Bau der Zelle erfolgte in einer Glovebox (< 1 ppm $H_2O$, $O_2$), der Wassergehalt in der Trockenmasse aller verwendeten Komponenten lag unterhalb von 20 ppm.

Die elektrochemische Testung wurde bei 20°C durchgeführt. Das Laden der Zelle erfolgte im cc/cv-Verfahren (constant current / constant voltage) mit konstantem Strom von 5 mA/g (entsprechend C/25) im ersten Zyklus und von 60 mA/g (entsprechend C/2) in den darauffolgenden Zyklen und nach Erreichen der Spannungsgrenze von 4,2 V mit konstanter Spannung bis Unterschreiten eines Stroms von 1,2 mA/g (entsprechend C/100) bzw. 15 mA/g (entspricht C/8). Das Entladen der Zelle erfolgte im cc-Verfahren (constant current) mit konstantem Strom von 5 mA/g (entsprechend C/25) im ersten Zyklus und von 60 mA/g (entsprechend C/2) in den darauffolgenden Zyklen bis Erreichen der Spannungsgrenze von 2,5 V. Der gewählte spezifische Strom bezog sich auf das Gewicht der Beschichtung der positiven Elektrode. Die Elektroden wurden so gewählt, dass ein Kapazitätsverhältnis von Kathode:Anode = 1:1,2 eingestellt wurde.

Folgende Testergebnisse wurden mit der Lithium-Ionen-Batterie-Vollzelle von Beispiel 4 erhalten:

- reversible spezifische Kapazität der negativen Elektrode im zweiten Zyklus:
  600 mAh/g (4,2 - 2,5 V); 534 mAh/g (4,2 - 3,0 V)
- Zyklenzahl mit ≥ 80% Kapazitätserhalt:
  302 Lade-/Entladezyklen.

Vergleichsbeispiel 5:

Anode mit Silicium enthaltenden Material aus Vergleichsbeispiel 3 und elektrochemische Testung in einer Lithium-Ionen-Batterie:

Mit dem nicht erfindungsgemäßen Silicium enthaltenden Material aus Vergleichsbeispiel 3 wurde eine Anode wie in Beispiel 4 beschrieben hergestellt. Die Anode wurde wie in Beispiel 4 beschrieben zu einer Lithium-Ionen-Batterie verbaut und nach gleicher Prozedur der Austestung unterzogen.

Folgende Testergebnisse wurden mit der Lithium-Ionen-Batterie-Vollzelle von Vergleichsbeispiel 5 erhalten:

- reversible spezifische Kapazität der negativen Elektrode im zweiten Zyklus:
  520 mAh/g (4,2 - 2,5 V); 490 mAh/g (4,2 - 3,0 V)
- Zyklenzahl mit ≥ 80% Kapazitätserhalt:
  35 Lade-/Entladezyklen.

Beispiel 6:

mikroporöses Bornitrid als poröse Partikel:

3,36 g Borsäure und 13,68 g Dicyandiamid wurden in 300 ml destilliertem Wasser bei Raumtemperatur gelöst. Die Lösung wurde dann auf 100°C erhitzt und unter Rühren soweit eingedampft, bis ein weißer kristalliner Feststoff (16,79 g) erhalten wurde. Danach wurde ein Quarzglasschiffchen mit 8,15 g mit dem so erhaltenen Zwischenprodukt befüllt und in einen Rohrofen eingebracht. Dieser wurde unter Formiergasstrom (5% $H_2$ in $N_2$, 12 Nl/h) mit einer Rate von 10 K/min auf 975°C aufgeheizt. Nach Erreichen der Zieltemperatur wurde auf einen $CO_2$-Gasstrom umgeschaltet (3 Nl/h) und für 5 h gehalten. Abschließend wurde unter Formiergasstrom (3 Nl/h) passiv auf Raumtemperatur abgekühlt. Es wurden 0,5 g weißer Feststoff erhalten.

BET-Oberfläche: 1006 $m^2$/g
Gesamtporenvolumen: 0,56 $cm^3$/g
Reversible Delithiierungskapazität $\beta$: 5 mAh/g
mittlerer elektrischer Partikelwiderstand: 72740 kOhm
PGV: $D_{50}$=6,8 $\mu$m. Spanne 0,81

Beispiel 7:

Silicium enthaltendes Material mit den porösen Partikeln aus Beispiel 6:
Ein Rohrreaktor wurde mit 3,0 g der porösen BN-Partikel aus Beispiel 6 in einem Quarzglasschiffchen beladen. Nach Inertisierung mit Stickstoff wurde der Reaktor auf 410°C erhitzt. Bei Erreichen der Reaktionstemperatur wurde das Reaktivgas (10% $SiH_4$ in $N_2$, 10 Nl/h) für 5,2 h durch den Reaktor geleitet. Der Reaktor wurde anschließend mit Inertgas gespült, bevor das Produkt bei 500°C für 1 h getempert wurde. Vor der Entnahme aus dem Reaktor wurde das Produkt unter Inertgas auf Raumtemperatur abgekühlt.

BET-Oberfläche: 14 $m^2$/g
PGV: $D_{50}$=6,8 $\mu$m, Spanne 0,81
abgeschiedener Si-Gehalt: 35 Gew.-%
Reversible Delithiierungskapazität $\beta$: 1210 mAh/g

Beispiel 8:

Anode mit dem Silicium enthaltenden Material aus Beispiel 7 und elektrochemische Testung in einer Lithium-Ionen-Batterie:
Mit dem erfindungsgemäßen Silicium enthaltenden Material aus Beispiel 7 wurde eine Anode wie in Beispiel 4 beschrieben hergestellt. Die Anode wurde wie in Beispiel 4 beschrieben zu einer Lithium-Ionen-Batterie verbaut und nach gleicher Prozedur der Austestung unterzogen.
Folgende Testergebnisse wurden mit der Lithium-Ionen-Batterie-Vollzelle von Beispiel 8 erhalten:

- reversible spezifische Kapazität der negativen Elektrode im zweiten Zyklus:
  740 mAh/g (4,2 - 2,5 V); 657 mAh/g (4,2 - 3,0 V)
- Zyklenzahl mit $\geq$ 80% Kapazitätserhalt:
  280 Lade-/Entladezyklen.

Vergleichsbeispiel 9:

Silicium enthaltendes Material auf Basis eines porösen Kohlenstoffs als poröse Partikel:
Ein Rohrreaktor wurde mit 3,0 g des porösen Kohlenstoffs (spez. Oberfläche = 1189 $m^2$/g, Porenvolumen = 0,65 $cm^3$/g, mittlerer elektrischer Partikelwiderstand 1,2 kOhm, reversible Kapazität $\beta$ = 389 mAh/g) in einem Quarzglasschiffchen beladen. Nach Inertisierung mit Stickstoff wurde der Reaktor auf 410°C erhitzt. Bei Erreichen der Reaktionstemperatur wurde das Reaktivgas (10% $SiH_4$ in $N_2$, 10 Nl/h) für 5,2 h durch den Reaktor geleitet. Der Reaktor wurde anschließend mit Inertgas gespült, bevor das Produkt bei 500°C für 1 h getempert wurde. Vor der Entnahme aus dem Reaktor wurde das Produkt unter Inertgas auf Raumtemperatur abgekühlt.

BET-Oberfläche: 32 $m^2$/g
PGV: $D_{50}$=3,9 $\mu$m, Spanne 0,86
abgeschiedener Si-Gehalt: 38 Gew.-%
Reversible Delithiierungskapazität $\beta$: 1130 mAh/g

Vergleichsbeispiel 10:

Anode mit dem Silicium enthaltenden Material aus Vergleichsbeispiel 9 und elektrochemische Testung in einer Lithium-Ionen-Batterie:

Mit dem nicht erfindungsgemäßen Silicium enthaltenden Material aus Vergleichsbeispiel 9 wurde eine Anode wie in Beispiel 4 beschrieben hergestellt. Die Anode wurde wie in Beispiel 4 beschrieben zu einer Lithium-Ionen-Batterie verbaut und nach gleicher Prozedur der Austestung unterzogen.

Folgende Testergebnisse wurden mit der Lithium-Ionen-Batterie-Vollzelle von Vergleichsbeispiel 10 erhalten:

- reversible spezifische Kapazität der negativen Elektrode im zweiten Zyklus:
  580 mAh/g (4,2 - 2,5 V); 464 mAh/g (4,2 - 3,0 V)
- Zyklenzahl mit $\geq$ 80% Kapazitätserhalt:
  174 Lade-/Entladezyklen.

Tabelle 1: Elektrochemische Kennwerte aus Vollzellmessungen der Si-haltigen Aktivmaterialien:

| | Porosität | Grundmaterial | Entladekapazität Anode nach Zyklus 1 [mAh/g] | Zyklenzahl mit $\geq$ 80% Kapazitätserhalt |
|---|---|---|---|---|
| Bsp. 4 | Mikro | $SiO_2$ | 600 | 302 |
| VBsp. 5 | Meso | $SiO_2$ | 520 | 35 |
| Bsp. 8 | Mikro | BN | 740 | 280 |
| VBsp. 10 | Mikro | C | 580 | 174 |

**Patentansprüche**

1. Silicium enthaltendes Material basierend auf einem oder mehreren porösen Partikeln und Silicium, wobei sich das Silicium in Poren und auf der Oberfläche der porösen Partikel befindet und das Silicium enthaltende Material eine spezifische Oberfläche von höchstens 50 $m^2$/g, bestimmt durch Stickstoff-Sorption und BET-Auswertung, aufweist, **dadurch gekennzeichnet, dass** die porösen Partikel

   a) einen mittleren elektrischen Partikelwiderstand von zumindest 2 kOhm und
   b) eine reversible Delithiierungs-Kapazität $\beta$ von höchstens 100 mAh/g aufweisen,

   wobei die porösen Partikel auf einem oder mehreren Materialien basieren, ausgewählt aus der Gruppe enthaltend Oxide, ausgewählt aus der Gruppe enthaltend Siliciumdioxid, Aluminiumoxid, Silicium-Aluminium-Mischoxide, Magnesiumoxid, Bleioxide und Zirkoniumoxid, Carbide, ausgewählt aus der Gruppe enthaltend Siliciumcarbide und Borcarbide, Nitride, ausgewählt aus der Gruppe enthaltend Siliciumnitride und Bornitride, sowie keramische Werkstoffe.

2. Silicium enthaltendes Material nach Anspruch 1, **dadurch gekennzeichnet, dass** die porösen Partikel auf einem keramischen Werkstoff basieren der allgemeinen Zusammensetzung $Al_aB_bC_cMg_dN_eO_fSi_g$ mit $0 \leq a, b, c, d, e, f, g \leq 1$; mit mindestens zwei Koeffizienten a bis g > 0 und $a*3 + b*3 + c*4 + d*2 + g*4 \geq e*3 + f*2$, umfassend die keramischen Werkstoffe ausgewählt aus der Gruppe enthaltend:

   - Nichtstöchiometrische Bornitride $BN_z$ mit z = 0,2 bis 1,
   - Nichtstöchiometrische Kohlenstoffnitride $CN_z$ mit z = 0,1 bis 4/3,
   - Borcarbonitride $B_xCN_z$ mit x = 0,1 bis 20 und z = 0,1 bis 20, wobei gilt $x*3 + 4 \geq z*3$,
   - Bornitridooxide $BN_zO_r$ mit z = 0,1 bis 1 und r = 0,1 bis 1, wobei gilt $3 \geq r*2 + z*3$,
   - Borcarbonitridooxide $B_xCN_zO_r$ mit x = 0,1 bis 2, z = 0,1 bis 1 und r = 0,1 bis 1, wobei gilt $x*3 + 4 \geq r*2 + z*3$,
   - Siliciumcarbooxide $Si_xCO_z$ mit x = 0,1 bis 2 und z = 0,1 bis 2, wobei gilt $x*4 + 4 \geq z*2$,
   - Siliciumcarbonitride $Si_xCN_z$ mit x = 0,1 bis 3 und z = 0,1 bis 4, wobei gilt $x*4 + 4 \geq z*3$,
   - Siliciumborocarbonitride $Si_wB_xCN_z$ mit w = 0,1 bis 3, x = 0,1 bis 2 und z= 0,1 bis 4, wobei gilt $w*4 + x*3 + 4 \geq z*3$,
   - Siliciumborocarbooxide $Si_wB_xCO_z$ mit w = 0,10 bis 3, x = 0,1 bis 2 und z = 0,1 bis 4, wobei gilt $w*4 + x*3 + 4 \geq z*2$,
   - Siliciumborocarbonitridooxide $Si_vB_wCN_xO_z$ mit v = 0,1 bis 3, w = 0,1 bis 2, x = 0,1 bis 4 und z = 0,1 bis 3, wobei gilt

$v*4 + w*3 + 4 \geq x*3 + z*2$ und

- Aluminiumborosilicocarbonitridooxide $Al_uB_vSi_xCN_wO_z$ mit u = 0,1 bis 2, v = 0,1 bis 2, w = 0,1 bis 4, x = 0,1 bis 2 und z = 0,1 bis 3, wobei gilt $u*3 + v*3 + x*4 + 4 \geq w*3 + z*2$.

3. Silicium enthaltendes Material nach einem der Ansprüche 1 bis 2, **dadurch gekennzeichnet, dass** die porösen Partikel eine durch Heliumpyknometrie bestimmte Dichte von 0,1 bis 7 g/cm$^3$ aufweisen.

4. Silicium enthaltendes Material nach einem der Ansprüche 1 bis 3, **dadurch gekennzeichnet, dass** die porösen Partikel eine volumengewichtete Partikelgrößenverteilung mit Durchmesser-Perzentilen $d_{50}$ von 0,5 bis 20 $\mu$m aufweisen.

5. Silicium enthaltendes Material nach einem der Ansprüche 1 bis 4, **dadurch gekennzeichnet, dass** das Silicium enthaltende Material eine volumengewichtete Partikelgrößenverteilung mit Durchmesser-Perzentilen $d_{50}$ von 0,5 bis 20 $\mu$m aufweist.

6. Silicium enthaltendes Material nach einem der Ansprüche 1 bis 5, **dadurch gekennzeichnet, dass** das Silicium enthaltende Material höchstens 30% Makroporen bezogen auf das Gesamtporenvolumen aufweist.

7. Silicium enthaltendes Material nach einem der Ansprüche 1 bis 6, **dadurch gekennzeichnet, dass** das Silicium enthaltende Material mindestens 50% Poren mit einem mittleren Porendurchmesser von höchstens 5 nm aufweist.

8. Silicium enthaltendes Material nach einem der Ansprüche 1 bis 7, **dadurch gekennzeichnet, dass** es mindestens 30 Gew.-% Silicium aufweist.

9. Silicium enthaltendes Material nach einem der Ansprüche 1 bis 8, **dadurch gekennzeichnet, dass** in Poren und auf der äußeren Oberfläche der porösen Partikel Silicium in Form von Schichten oder in Form von aus Siliciumpartikeln gebildeten Schichten mit einer Dicke von höchstens 1 $\mu$m vorliegt.

10. Verfahren zur Herstellung von Silicium enthaltendem Material nach zumindest einem der Ansprüche 1 bis 9, bei dem ein oder mehrere Silicium-Präkursoren in Gegenwart von einem oder mehreren porösen Partikeln thermisch zersetzt werden, wodurch in Poren und auf der Oberfläche der porösen Partikel Silicium abgeschieden wird, wobei das Silicium enthaltende Material eine spezifische Oberfläche von höchstens 50 m$^2$/g, bestimmt durch Stickstoff-Sorption und BET-Auswertung, aufweist, **dadurch gekennzeichnet, dass** poröse Partikel

    a) einen mittleren elektrischen Partikelwiderstand von zumindest 2 kOhm und
    b) eine reversible Delithiierungs-Kapazität $\beta$ von höchstens 100 mAh/g aufweisen,

    wobei die porösen Partikel auf einem oder mehreren Materialien basieren, ausgewählt aus der Gruppe enthaltend Oxide, ausgewählt aus der Gruppe enthaltend Siliciumdioxid, Aluminiumoxid, Silicium-Aluminium-Mischoxide, Magnesiumoxid, Bleioxide und Zirkoniumoxid, Carbide, ausgewählt aus der Gruppe enthaltend Siliciumcarbide und Borcarbide, Nitride, ausgewählt aus der Gruppe enthaltend Siliciumnitride und Bornitride, sowie keramische Werkstoffe.

11. Verfahren nach Anspruch 10, **dadurch gekennzeichnet, dass** die Abscheidung von Silicium aus den Silicium-Präkursoren in einem Reaktor, ausgewählt aus der Gruppe enthaltend Wirbelschichtreaktoren, horizontal bis hin zu vertikal angeordneten Drehrohröfen, offene oder geschlossene FestbettReaktoren und Druckreaktoren, erfolgt.

12. Anodenmaterial zur Verwendung in Lithium-Ionen-Batterien, enthaltend 5 bis 95 Gew.-% des Silicium enthaltenden Materials nach einem der Ansprüche 1 bis 9, 0 bis 90 Gew.-% einer oder mehrerer weiterer elektrisch leitender Komponenten, 0 bis 90 Gew.-% Graphit, 0 bis 25 Gew.-% Bindemittel und 0 bis 80 Gew.-% weiterer Additive, wobei sich die Angaben in Gew.-% auf das Gesamtgewicht des Anodenmaterials beziehen und sich die Anteile aller Bestandteile des Anodenmaterials auf 100 Gew.-% aufsummieren.

13. Anode umfassend einen Stromableiter, der mit einem Anodenmaterial gemäß Anspruch 12 beschichtet ist.

14. Lithium-Ionen-Batterien umfassend eine Kathode, eine Anode, zwei elektrisch leitende Anschlüsse an den Elektroden, einen Separator und einen Elektrolyten, mit dem der Separator und die beiden Elektroden getränkt sind, sowie ein die genannten Teile aufnehmendes Gehäuse, **dadurch gekennzeichnet, dass** die Anode Silicium enthaltendes Material nach einem der Ansprüche 1 bis 9 enthält.

## Claims

1. Silicon-containing material based on one or more porous particles and silicon, wherein the silicon is disposed in pores and on the surface of the porous particles and the silicon-containing material has a specific surface area of at most 50 $m^2/g$, determined by nitrogen sorption and BET evaluation, **characterized in that** the porous particles have

   a) a mean electrical particle resistance of at least 2 kOhm and
   b) a reversible delithiation capacity $\beta$ of at most 100 mAh/g,

   wherein the porous particles are based on one or more materials selected from the group comprising oxides selected from the group comprising silicon dioxide, aluminium oxide, silicon-aluminium mixed oxides, magnesium oxide, lead oxides and zirconium oxide, carbides selected from the group comprising silicon carbides and boron carbides, nitrides selected from the group comprising silicon nitrides and boron nitrides, and ceramic materials.

2. Silicon-containing material according to Claim 1, **characterized in that** the porous particles are based on a ceramic material of the general composition $Al_aB_bC_cMg_dN_eO_fSi_g$ where $0 \leq a, b, c, d, e, f, g \leq 1$; where at least two coefficients a to g are > 0 and $a*3 + b*3 + c*4 + d*2 + g*4 \geq e*3 + f*2$, comprising the ceramic materials selected from the group comprising:

   - non-stoichiometric boron nitrides $BN_z$ where z = 0.2 to 1,
   - non-stoichiometric carbon nitrides $CN_z$ where z = 0.1 to 4/3,
   - boron carbonitrides $B_xCN_z$ where x = 0.1 to 20 and z = 0.1 to 20, where $x*3 + 4 \geq z*3$,
   - boron nitride oxides $BN_zO_r$ where z = 0.1 to 1 and r = 0.1 to 1, where $3 \geq r*2 + z*3$,
   - boron carbonitride oxides $B_xCN_zO_r$ where x = 0.1 to 2, z = 0.1 to 1 and r = 0.1 to 1, where $x*3 + 4 \geq r*2 + z*3$,
   - silicon carbon oxides $Si_xCO_z$ where x = 0.1 to 2 and z = 0.1 to 2, where $x*4 + 4 \geq z*2$,
   - silicon carbonitrides $Si_xCN_z$ where x = 0.1 to 3 and z = 0.1 to 4, where $x*4 + 4 \geq z*3$,
   - silicon boron carbonitrides $Si_wB_xCN_z$ where w = 0.1 to 3, x = 0.1 to 2 and z = 0.1 to 4, where $w*4 + x*3 + 4 \geq z*3$,
   - silicon boron carbon oxides $Si_wB_xCO_z$ where w = 0.10 to 3, x = 0.1 to 2 and z = 0.1 to 4, where $w*4 + x*3 + 4 \geq z*2$,
   - silicon boron carbonitride oxides $Si_vB_wCN_xO_z$ where v = 0.1 to 3, w = 0.1 to 2, x = 0.1 to 4 and z = 0.1 to 3, where $v*4 + w*3 + 4 \geq x*3 + z*2$ and
   - aluminium boron silicon carbonitride oxides $Al_uB_vSi_xCN_wO_z$ where u = 0.1 to 2, v = 0.1 to 2, w = 0.1 to 4, x = 0.1 to 2 and z = 0.1 to 3, where $u*3 + v*3 + x*4 + 4 \geq w*3 + z*2$.

3. Silicon-containing material according to any of Claims 1 to 2, **characterized in that** the porous particles have a density determined by helium pycnometry of 0.1 to $_7$ g/cm$^3$.

4. Silicon-containing material according to any of Claims 1 to 3, **characterized in that** the porous particles have a volume-weighted particle size distribution with diameter percentiles $d_{50}$ from 0.5 to 20 $\mu$m.

5. Silicon-containing material according to any of Claims 1 to 4, **characterized in that** the silicon-containing material has a volume-weighted particle size distribution with diameter percentiles $d_{50}$ from 0.5 to 20 $\mu$m.

6. Silicon-containing material according to any of Claims 1 to 5, **characterized in that** the silicon-containing material has at most 30% macropores, based on the total pore volume.

7. Silicon-containing material according to any of Claims 1 to 6, **characterized in that** the silicon-containing material has at least 50% of pores with a mean pore diameter of at most 5 nm.

8. Silicon-containing material according to any of Claims 1 to 7, **characterized in that** it comprises at least 30% by weight silicon.

9. Silicon-containing material according to any of Claims 1 to 8, **characterized in that** silicon is present in pores and on the outer surface of the porous particles in the form of layers or in the form of layers formed from silicon particles having a thickness of at most 1 $\mu$m.

10. Process of producing silicon-containing material according to at least one of Claims 1 to 9, in which process one or more silicon precursors are thermally decomposed in the presence of one or more porous particles, thereby depositing silicon in pores and on the surface of the porous particles, the silicon-containing material having a specific surface area of at most 50 m$^2$/g, determined by nitrogen sorption and BET evaluation, **characterized in that** the porous particles have

    a) a mean electrical particle resistance of at least 2 kOhm and
    b) a reversible delithiation capacity $\beta$ of at most 100 mAh/g,

wherein the porous particles are based on one or more materials selected from the group comprising oxides selected from the group comprising silicon dioxide, aluminium oxide, silicon-aluminium mixed oxides, magnesium oxide, lead oxides and zirconium oxide, carbides selected from the group comprising silicon carbides and boron carbides, nitrides selected from the group comprising silicon nitrides and boron nitrides, and ceramic materials.

11. Process according to Claim 10, **characterized in that** the silicon is deposited from the silicon precursors in a reactor selected from the group comprising fluidized bed reactors, rotary kilns oriented from horizontal to vertical, open or closed fixed-bed reactors, and pressure reactors.

12. Anode material for use in lithium-ion batteries, comprising 5 to 95% by weight of the silicon-containing material according to any of Claims 1 to 9, 0 to 90% by weight of one or more further electrically conducting components, 0 to 90% by weight of graphite, 0 to 25% by weight of binder and 0 to 80% by weight of further additives, wherein the percentages by weight refer to the total weight of the anode material and the proportions of all constituents of the anode material add up to 100% by weight.

13. Anode comprising a current collector coated with an anode material according to Claim 12.

14. Lithium-ion batteries comprising a cathode, an anode, two electrically conducting connections to the electrodes, a separator and an electrolyte with which the separator and the two electrodes are impregnated, and a housing accommodating the parts specified, **characterized in that** the anode comprises silicon-containing material according to any of Claims 1 to 9.

**Revendications**

1. Matériau contenant du silicium à base d'une ou de plusieurs particules poreuses et de silicium, dans lequel le silicium se trouve dans les pores et à la surface des particules poreuses et le matériau contenant du silicium présente une surface spécifique d'au plus 50 m$^2$/g, déterminée par sorption d'azote et évaluation BET, **caractérisé en ce que** les particules poreuses présentent

    a) une résistance électrique moyenne des particules d'au moins 2 kOhm et
    b) une capacité de délithiation réversible $\beta$ d'au plus 100 mAh/g,

les particules poreuses étant à base d'un ou de plusieurs matériaux choisis dans le groupe contenant des oxydes choisis dans le groupe contenant le dioxyde de silicium, l'oxyde d'aluminium, les oxydes mixtes de silicium-aluminium, l'oxyde de magnésium, les oxydes de plomb et l'oxyde de zirconium, des carbures choisis dans le groupe contenant les carbures de silicium et les carbures de bore, des nitrures choisis dans le groupe contenant les nitrures de silicium et les nitrures de bore, ainsi que des matériaux céramiques.

2. Matériau contenant du silicium selon la revendication 1, **caractérisé en ce que** les particules poreuses sont à base d'un matériau céramique de composition générale $Al_aB_bC_cMg_dN_eO_fSi_g$ où $0 \leq a, b, c, d, e, f, g \leq 1$ ; où au moins deux coefficients a à g sont $> 0$ et $a*3 + b*3 + c*4 + d*2 + g*4 \geq e*3 + f*2$, comprenant les matériaux céramiques choisis dans le groupe contenant :

    - les nitrures de bore non stoechiométriques $BN_z$ où $z = 0,2$ à 1,
    - les nitrures de carbone non stoechiométriques $CN_z$ où $z = 0,1$ à 4/3,
    - les carbonitrures de bore $B_xCN_z$ où $x = 0,1$ à 20 et $z = 0,1$ à 20, où $x*3 + 4 \geq z*3$,
    - les oxydes de nitrure de bore $BN_zO_r$ où $z = 0,1$ à 1 et $r = 0,1$ à 1, où $3 \geq r*2 + z*3$,
    - les oxydes de carbonitrure de bore $B_xCN_zO_r$ où $x = 0,1$ à 2, $z = 0,1$ à 1 et $r = 0,1$ à 1, où $x*3 + 4 \geq r*2 + z*3$,

- les carboxydes de silicium $Si_xCO_z$ où x = 0,1 à 2 et z = 0,1 à 2, où x*4 + 4 $\geq$ z*2,
- les carbonitrures de silicium $Si_xCN_z$ où x = 0,1 à 3 et z = 0,1 à 4, où x*4 + 4 $\geq$ z*3,
- les borocarbonitrures de silicium $Si_wB_xCN_z$ où w = 0,1 à 3, x = 0,1 à 2 et z = 0,1 à 4, où w*4 + x*3 + 4 $\geq$ z*3,
- les borocarboxydes de silicium $Si_wB_xCO_z$ où w = 0,10 à 3, x = 0,1 à 2 et z = 0,1 à 4, où w*4 + x*3 + 4 $\geq$ z*2,
- les oxydes de borocarbonitrure de silicium $Si_vB_wCN_xO_z$ où v = 0,1 à 3, w = 0,1 à 2, x = 0,1 à 4 et z = 0,1 à 3, où v*4 + w*3 + 4 $\geq$ x*3 + z*2 et
- les oxydes de borosilicocarbonitrure d'aluminium $Al_uB_vSi_xCN_wO_z$ où u = 0,1 à 2, v = 0,1 à 2, w = 0,1 à 4, × = 0,1 à 2 et z = 0,1 à 3, où u*3 + v*3 + x*4 + 4 $\geq$ w*3 + z*2.

3. Matériau contenant du silicium selon l'une des revendications 1 à 2, **caractérisé en ce que** les particules poreuses présentent une masse volumique de 0,1 à 7 g/cm³, déterminée par pycnométrie à l'hélium.

4. Matériau contenant du silicium selon l'une des revendications 1 à 3, **caractérisé en ce que** les particules poreuses présentent une distribution granulométrique pondérée en volume présentant des percentiles de diamètre $d_{50}$ de 0,5 à 20 $\mu$m.

5. Matériau contenant du silicium selon l'une des revendications 1 à 4, **caractérisé en ce que** le matériau contenant du silicium présente une distribution granulométrique pondérée en volume présentant des percentiles de diamètre $d_{50}$ de 0,5 à 20 $\mu$m.

6. Matériau contenant du silicium selon l'une des revendications 1 à 5, **caractérisé en ce que** le matériau contenant du silicium présente au plus 30% de macropores par rapport au volume total de pores.

7. Matériau contenant du silicium selon l'une des revendications 1 à 6, **caractérisé en ce que** le matériau contenant du silicium présente au moins 50% de pores présentant un diamètre moyen de pore d'au plus 5 nm.

8. Matériau contenant du silicium selon l'une des revendications 1 à 7, **caractérisé en ce qu'**il contient au moins 30% en poids de silicium.

9. Matériau contenant du silicium selon l'une des revendications 1 à 8, **caractérisé en ce que** du silicium sous forme de couches ou sous forme de couches formées de particules de silicium d'une épaisseur d'au plus 1 $\mu$m est présent dans les pores et sur la surface externe des particules poreuses.

10. Procédé de préparation de matériau contenant du silicium selon au moins l'une des revendications 1 à 9, dans lequel un ou plusieurs précurseurs de silicium sont décomposés thermiquement en présence d'une ou de plusieurs particules poreuses, suite à quoi du silicium est déposé dans les pores et à la surface des particules poreuses, le matériau contenant du silicium présentant une surface spécifique d'au plus 50 m²/g, déterminée par sorption d'azote et évaluation BET, **caractérisé en ce que** des particules poreuses présentent

    a) une résistance électrique moyenne des particules d'au moins 2 kOhm et
    b) une capacité de délithiation réversible $\beta$ d'au plus 100 mAh/g,

les particules poreuses étant à base d'un ou de plusieurs matériaux choisis dans le groupe contenant des oxydes choisis dans le groupe contenant le dioxyde de silicium, l'oxyde d'aluminium, les oxydes mixtes de silicium-aluminium, l'oxyde de magnésium, les oxydes de plomb et l'oxyde de zirconium, des carbures choisis dans le groupe contenant les carbures de silicium et les carbures de bore, des nitrures choisis dans le groupe contenant les nitrures de silicium et les nitrures de bore, ainsi que des matériaux céramiques.

11. Procédé selon la revendication 10, **caractérisé en ce que** le dépôt de silicium à partir des précurseurs de silicium a lieu dans un réacteur choisi dans le groupe comprenant les réacteurs à lit tourbillonnant, les fours tubulaires rotatifs disposés horizontalement jusqu'à verticalement, les réacteurs à lit fixe ouverts ou fermés et les réacteurs sous pression.

12. Matériau anodique destiné à être utilisé dans des batteries lithium-ion, comprenant 5 à 95% en poids du matériau contenant du silicium selon l'une des revendications 1 à 9, 0 à 90% en poids d'un ou plusieurs autres composants électriquement conducteurs, 0 à 90% en poids de graphite, 0 à 25% en poids de liant et 0 à 80% en poids d'autres additifs, les indications en % en poids se rapportant au poids total du matériau anodique et la somme des proportions de tous les constituants du matériau valant 100% en poids.

**13.** Anode comprenant un collecteur de courant revêtu d'un matériau anodique selon la revendication 12.

**14.** Batteries lithium-ion comprenant une cathode, une anode, deux connexions électriquement conductrices au niveau des électrodes, un séparateur et un électrolyte, dont le séparateur et les deux électrodes sont imprégnés, et un boîtier logeant les pièces mentionnées, **caractérisées en ce que** l'anode contient un matériau contenant du silicium selon l'une des revendications 1 à 9.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1730800 B1
- US 10559812 B2
- US 10819400 B2
- EP 3335262 B1
- US 10147950 B2
- US 10424786 B1
- WO 2012097969 A1
- US 9005818 B2
- WO 2020128523 A1
- WO 2017040299 A1
- WO 2018145765 A1
- EP 3678990 A1
- EP 1323783 B1
- US 10147950 B1

**In der Beschreibung aufgeführte Nicht-Patentliteratur**

- **M. OBROVAC** ; **V.L. CHEVRIER**. *Chem. Rev.*, 2014, vol. 114, 11444
- **M. KATO** ; **K. SAKAI-KATO** ; **T TOYO'OKA**. *J. Sep. Science*, 2005, vol. 28, 1893-1908
- The Probable Error of a Mean. *Biometrika*, March 1908, vol. 6 (1), 1-259